# EUROPEAN PATENT APPLICATION

(11) **EP 4 024 445 A1**
(43) Date of publication of application: **06.07.2022**
(21) Application number: 20856020.1
(22) Date of filing: 24.08.2020
(51) Int. Cl.: H01L 23/36, C08L 63/00, C08K 3/00

(54) **COMPOSITION FOR FORMING HEAT-CONDUCTING MATERIAL, HEAT-CONDUCTING MATERIAL, HEAT-CONDUCTING SHEET, AND DEVICE WITH HEAT-CONDUCTING LAYER**

(30) Priority: 26.08.2019 JP 2019153949
(71) Applicant: FUJIFILM Corporation, Tokyo 106-8620 (JP)
(72) Inventor: HITOMI, Seiichi, Ashigarakami-gun, Kanagawa 258-8577 (JP); TAKAHASHI, Keita, Ashigarakami-gun, Kanagawa 258-8577 (JP); NIORI, Teruki, Ashigarakami-gun, Kanagawa 258-8577 (JP); HAYASHI, Daisuke, Ashigarakami-gun, Kanagawa 258-8577 (JP)
(74) Representative: HGF
(86) International application number: PCT/JP2020/031867
(87) International publication number: WO 2021/039732

(57) **Abstract**

An object of the present invention is to provide a composition for forming a thermally conductive material, from which a thermally conductive material having excellent thermally conductive properties can be obtained. In addition, another object of the present invention is to provide a thermally conductive material formed of the composition for forming a thermally conductive material, a thermally conductive sheet, and a device with a thermally conductive layer.

A composition for forming a thermally conductive material of the present invention includes an epoxy compound, an inorganic substance, and a compound X containing one or more functional groups selected from the group consisting of an alkenyl group, an acrylate group, a methacrylate group, a silyl group, an acid anhydride group, a cyanate ester group, an amino group, a thiol group, and a carboxylic acid group, or having a polyamic acid structure, in which a content of the inorganic substance is 10% by mass or more with respect to a total solid content of the composition, and a content of the compound X is 10% by mass or more with respect to the total solid content of the composition.

## Description

### BACKGROUND OF THE INVENTION

### 1. Field of the Invention

The present invention relates to a composition for forming a thermally conductive material, a thermally conductive material, a thermally conductive sheet, and a device with a thermally conductive layer.

### 2. Description of the Related Art

In recent years, a power semiconductor device used in various electrical machines such as a personal computer, a general household electric appliance, and an automobile has been rapidly miniaturized. With the miniaturization, it is difficult to control heat generated from the power semiconductor device having a high density.

In order to deal with such a problem, a thermally conductive material, which promotes heat dissipation from the power semiconductor device, is used.

For example, JP2019-6837A discloses "a thermally conductive sheet provided with a sheet body formed of a thermally curable resin composition, in which the thermally curable resin composition comprises a thermosetting resin and inorganic nitride particles, contains the inorganic nitride particles in 50% by volume or more, and the inorganic nitride particles contain aluminum nitride particles having a particle diameter of 30 µm or less in a proportion of 15% by volume or more and aluminum nitride particles having a particle diameter of 20 µm or less in a proportion of 10% by volume or more, and aluminum nitride particles having a particle diameter of 10 µm or less in a proportion of 5% by volume or more (claim 1)". As the inorganic nitride particles, those in which a part or all of the surface thereof is treated with a silane coupling agent have been proposed (claim 3).

### SUMMARY OF THE INVENTION

The present inventors have studied a thermally conductive sheet described in JP2019-6837A, and have found that there is room for improvement in the thermally conductive properties.

Therefore, an object of the present invention is to provide a composition for forming a thermally conductive material, from which a thermally conductive material having excellent thermally conductive properties can be obtained.

Moreover, another object of the present invention is to provide a thermally conductive material formed of the composition for forming a thermally conductive material, a thermally conductive sheet, and a device with a thermally conductive layer.

As a result of a thorough examination conducted to achieve the objects, the present inventors have found that the objects can be achieved by the following configuration.
[1] A composition for forming a thermally conductive material, comprising: an epoxy compound;
   an inorganic substance; and
   a compound X containing one or more functional groups selected from the group consisting of an alkenyl group, an acrylate group, a methacrylate group, a silyl group, an acid anhydride group, a cyanate ester group, an amino group, a thiol group, and a carboxylic acid group, or having a polyamic acid structure,
   in which a content of the inorganic substance is 10% by mass or more with respect to a total solid content of the composition, and
   a content of the compound X is 10% by mass or more with respect to the total solid content of the composition.
[2] The composition for forming a thermally conductive material as described in [1], further comprising: a phenolic compound.
[3] The composition for forming a thermally conductive material as described in [2], in which a hydroxyl group content of the phenolic compound is 12.0 mmol/g or more.
[4] The composition for forming a thermally conductive material as described in [2] or [3], in which the phenolic compound has a molecular weight of 400 or less.
[5] The composition for forming a thermally conductive material as described in any one of [1] to [4], in which the compound X contains one or more functional groups selected from the group consisting of an alkenyl group, an acrylate group, a methacrylate group, and a silyl group, or has a polyamic acid structure.
[6] The composition for forming a thermally conductive material as described in any one of [1] to [5], in which the compound X is a linear or branched organopolysiloxane and has two or more alkenyl groups bonded to a silicon atom.
[7] The composition for forming a thermally conductive material as described in any one of [1] to [6], in which the content of the compound X is 15% to 35% by mass with respect to the total solid content of the composition.
[8] The composition for forming a thermally conductive material as described in any one of [1] to [7], in which the inorganic substance includes an inorganic nitride.
[9] The composition for forming a thermally conductive material as described in [8], in which the inorganic nitride includes boron nitride.
[10] The composition for forming a thermally conductive material as described in any one of [1] to [9], further comprising a surface modifier of the inorganic substance.
[11] The composition for forming a thermally conductive material as described in [10], in which the surface modifier has a condensed ring skeleton or a triazine skeleton.
[12] The composition for forming a thermally conductive material as described in any one of [1] to [11], further comprising: a curing accelerator.
[13] A thermally conductive material which is obtained by curing the composition for forming a thermally conductive material as described in any one of [1] to [12].
[14] A thermally conductive sheet made of the thermally conductive material as described in [13].
[15] A device with a thermally conductive layer comprising: a device; and a thermally conductive layer including the thermally conductive sheet as described in [14] arranged on the device.

According to the present invention, it is possible to provide a composition for forming a thermally conductive material, from which a thermally conductive material having excellent thermally conductive properties can be obtained.

In addition, according to the present invention, it is possible to provide a thermally conductive material formed of the composition for forming a thermally conductive material, a thermally conductive sheet, and a device with a thermally conductive layer.

### DESCRIPTION OF THE PREFERRED EMBODIMENTS

Hereinafter, the composition for forming a thermally conductive material, the thermally conductive material, the thermally conductive sheet, and the device with a thermally conductive layer according to an embodiment of the present invention will be described in detail.

The following constituent elements are described based on the representative embodiments of the present invention in some cases, but the present invention is not limited to such an embodiment.

Moreover, in the present specification, the numerical range expressed using "to" means a range including the numerical values listed before and after "to" as a lower limit value and an upper limit value.

In addition, in the present specification, the oxiranyl group is a functional group also called an epoxy group. For example, a group in which two adjacent carbon atoms of a saturated hydrocarbon ring group are bonded by an oxo group (-O-) to form an oxirane ring and the like are also included in the oxiranyl group. The oxiranyl group may or may not have a substituent (such as a methyl group), if possible.

In addition, in the present specification, the description of "(meth)acryloyl group" means "either or both of an acryloyl group and a methacryloyl group". Moreover, the description of "(meth)acrylamide group" means "either or both of an acrylamide group and a methacrylamide group". In addition, the description of "(meth)acrylate group" means "either or both of an acrylate group and a methacrylate group".

In the present specification, an acid anhydride group may be a monovalent group or a divalent group. In a case where the acid anhydride group represents a monovalent group, examples of the monovalent group include a substituent obtained by removing any hydrogen atom from an acid anhydride such as maleic acid anhydride, phthalic acid anhydride, pyromellitic acid anhydride, and trimellitic acid anhydride. Moreover, in a case where the acid anhydride group represents a divalent group, the divalent group means a group represented by ^{∗}-CO-O-CO-^{∗} (^{∗} represents a bonding position).

In addition, in the present specification, in a case where the description of "may have a substituent" appears, the kind of a substituent, the position of a substituent, and the number of substituents are not particularly limited. Examples of the number of substituents include 1 or 2 or more. Examples of the substituent include a monovalent nonmetallic atomic group excluding a hydrogen atom, and the substituent can be selected from the following substituent group Y.

Substituent group Y:
a halogen atom (-F, -Br, -Cl, -I), a hydroxyl group, an amino group, a carboxylic acid group and a conjugated base group thereof, a carboxylic acid anhydride group, a cyanate ester group, an unsaturated polymerizable group, an oxiranyl group, an oxetanyl group, an aziridinyl group, a thiol group, an isocyanate group, an thioisocyanate group, an aldehyde group, an alkoxy group, an aryloxy group, an alkylthio group, an arylthio group, an alkyldithio group, an aryldithio group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsufinyl group, an arylsulfinyl group, an alkylsulfonyl group, an arylsulfonyl group, a sulfo group (-SO₃H) and a conjugated base group thereof, an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and a conjugated base group thereof, an N-alkylsulfonylsulfamoyl group (-SO₂NHSO₂(alkyl)) and a conjugated base group thereof, an N-arylsulfonylsulfamoyl group (-SO₂NHSO₂(aryl)) and a conjugated base group thereof, an N-alkylsulfonylcarbamoyl group (-CONHSO₂(alkyl)) and a conjugated base group thereof, an N-arylsulfonylcarbamoyl group (-CONHSO₂(aryl)) and a conjugated base group thereof, an alkoxysilyl group (-Si(Oalkyl)₃), an aryloxysilyl group (-Si(Oaryl)₃), a hydroxysilyl group (-Si(OH)₃) and a conjugated base group thereof, a phosphono group (-PO₃H₂) and a conjugated base group thereof, a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and a conjugated base group thereof, a monoarylphosphono group (-PO₃H(aryl)) and a conjugated base group thereof, a phosphonooxy group (-OPO₃H₂) and a conjugated base group thereof, a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and a conjugated base group thereof, a monoarylphosphonooxy group (-OPO₃H(aryl)) and a conjugated base group thereof, a cyano group, a nitro group, an aryl group, an alkenyl group, an alkynyl group, and an alkyl group.

Moreover, these substituents may or may not form a ring by being bonded to each other, if possible, or by being bonded to a group substituted with the substituent.

Further, in the present specification, the weight average molecular weight is defined as a polystyrene-equivalent value by a Gel Permeation Chromatography (GPC) method.

### [Composition]

The composition for forming a thermally conductive material according to the embodiment of the present invention (hereinafter, also simply referred to as "composition") is
a composition for forming a thermally conductive material, comprising an epoxy compound,
an inorganic substance; and
and a compound X,
in which a content of the inorganic substance is 10% by mass or more with respect to a total solid content of the composition, and
a content of the compound X is 10% by mass or more with respect to the total solid content of the composition.

The compound X is a compound (hereinafter, also referred to as "compound XI") containing one or more functional groups selected from the group consisting of an alkenyl group, an acrylate group, a methacrylate group, a silyl group, an acid anhydride group, a cyanate ester group, an amino group, a thiol group, and a carboxylic acid group, or a compound having a polyamic acid structure (hereinafter, also referred to as "compound X2").

Although the mechanism by which the object of the present invention is achieved by the aforementioned constitution of the composition of the present invention is not always clear, the present inventors estimate as follows.

That is, in a case where the composition according to the embodiment of the present invention contains the compound X1 in a predetermined amount, a crosslinked structure by a reaction between the epoxy compound and the compound X1 and/or a crosslinked structure by a reaction between the compounds X1 is likely to be formed, and a dense crosslinked structure with many crosslinking points is easily formed. In addition, in a case where the composition according to the embodiment of the present invention contains the compound X2 in a predetermined amount, a dense crosslinked structure is likely to be formed by intermolecular interaction of the polyamic acid structure. That is, it is estimated that in a case where the composition according to the embodiment of the present invention contains the compound X in a predetermined amount, a dense crosslinked structure is likely to be formed, and the thermally conductive properties of the obtained thermally conductive material is improved.

In particular, in a case where the composition according to the embodiment of the present invention further contains a phenolic compound, the aforementioned effects are even more excellent. In a case where the composition according to the embodiment of the present invention contains a phenolic compound, the epoxy compound acts as a so-called main agent, and the phenolic compound acts as a so-called curing agent. In a case where the composition according to the embodiment of the present invention contains the compound X (compound X1 and/or compound X2) in a predetermined amount and contains a phenolic compound, in addition to the aforementioned dense crosslinked structure based on the compound X, a crosslinked structure between an epoxy compound and a phenolic compound is further formed, and thus the aforementioned effects are even more excellent.

In addition, it is estimated that the composition according to the embodiment of the present invention exhibits excellent thermally conductive properties by containing an inorganic substance in a predetermined amount.

In addition, the thermally conductive material obtained from the composition according to the embodiment of the present invention has good insulating properties (electrical insulating properties) and adhesiveness.

Hereinafter, the components contained in the composition will be described in detail.

### [Epoxy compound]

The composition according to the embodiment of the present invention contains an epoxy compound.

The epoxy compound is a compound having at least one epoxy group (oxiranyl group) in one molecule. The epoxy group may or may not have a substituent, if possible.

The number of epoxy groups contained in the epoxy compound is preferably 2 or greater, more preferably 2 to 40, even more preferably 2 to 10, and particularly preferably 2, in one molecule.

A molecular weight of the epoxy compound is preferably 150 to 10,000, more preferably 150 to 2,000, and even more preferably 200 to 600.

A lower limit value of the epoxy group content of the epoxy compound is preferably 2.0 mmol/g or greater, more preferably 4.0 mmol/g or greater, and even more preferably 5.0 mmol/g or greater. An upper limit value thereof is preferably 20.0 mmol/g or less, more preferably 15.0 mmol/g or less, and even more preferably 10.0 mmol/g or less.

The epoxy group content means the number of epoxy groups contained in 1 g of the epoxy compound.

The epoxy compound is preferably liquid at normal temperature (23°C).

The epoxy compound may or may not exhibit liquid crystallinity.

That is, the epoxy compound may be a liquid crystal compound. In other words, a liquid crystal compound having an epoxy group can also be used as the epoxy compound.

Examples of the epoxy compound (which may be a liquid crystalline epoxy compound) include a compound (rod-like compound) which has a rod-like structure in at least a portion thereof, and a compound (disk-like compound) which has a disk-like structure in at least a portion thereof.

Among them, a rod-like compound is preferable from the viewpoint that the thermally conductive properties of the obtained thermally conductive material are superior.

Hereinafter, the rod-like compound and the disk-like compound will be described in detail.

### <Rod-like compound>

Examples of the epoxy compounds, which are rod-like compounds, include azomethines, azoxies, cyanobiphenyls, cyanophenyl esters, benzoic acid esters, cyclohexane carboxylic acid phenyl esters, cyanophenyl cyclohexanes, cyano-substituted phenylpyrimidines, alkoxy-substituted phenylpyrimidines, phenyldioxanes, tolanes, and alkenylcyclohexyl benzonitriles. In addition to these low-molecular-weight compounds described above, high-molecular-weight compounds can also be used. The aforementioned high-molecular-weight compounds are high-molecular-weight compounds obtained by polymerizing rod-like compounds having a low-molecular-weight reactive group.

Examples of a preferred rod-like compound include a rod-like compound represented by General Formula (XXI).

General Formula (XXI): Q¹-L¹¹¹-A¹¹¹-L¹¹³-M-L¹¹⁴-A¹¹²-L¹¹²-Q²

In General Formula (XXI), Q¹ and Q² are each independently an epoxy group, and L¹¹¹, L¹¹², L¹¹³, and L¹¹⁴ each independently represent a single bond or a divalent linking group. A¹¹¹ and A¹¹² each independently represent a divalent linking group (spacer group) having 1 to 20 carbon atoms. M represents a mesogenic group.

The epoxy group of Q¹ and Q² may or may not have a substituent.

In General Formula (XXI), L¹¹¹, L¹¹², L¹¹³, and L¹¹⁴ each independently represent a single bond or a divalent linking group.

The divalent linking groups represented by L¹¹¹, L¹¹², L¹¹³, and L¹¹⁴ are preferably each independently a divalent linking group selected from the group consisting of -O-, -S-, -CO-, -NR¹¹²-, -CO-O-, and -O-CO-O-, -CO-NR¹¹²-, -NR¹¹²-CO-, -O-CO-, -CH₂-O-, -O-CH₂-, -O-CO-NR¹¹²-, -NR¹¹²-CO-O-, and -NR¹¹²-CO-NR¹¹²-. R¹¹² is an alkyl group or a hydrogen atom having 1 to 7 carbon atoms.

Among them, L¹¹³ and L¹¹⁴ are each independently preferably -O-.

L¹¹¹ and L¹¹² are each independently preferably a single bond.

In General Formula (XXI), A¹¹¹ and A¹¹² each independently represent a divalent linking group having 1 to 20 carbon atoms.

The divalent linking group may contain heteroatoms such as non-adjacent oxygen and sulfur atoms. Among them, an alkylene group, an alkenylene group, or an alkynylene group, having 1 to 12 carbon atoms is preferable. The aforementioned alkylene group, alkenylene group, or alkynylene group may or may not have an ester group.

The divalent linking group is preferably linear, and the divalent linking group may or may not have a substituent. Examples of the substituent include a halogen atom (fluorine atom, chlorine atom, and bromine atom), a cyano group, a methyl group, and an ethyl group.

Among them, A¹¹¹ and A¹¹² are each independently preferably an alkylene group having 1 to 12 carbon atoms, and more preferably a methylene group.

In General Formula (XXI), M represents a mesogenic group, and examples of the mesogenic group include known mesogenic groups. Among them, a group represented by General Formula (XXII) is preferable.

General Formula (XXII): -(W¹-O¹¹⁵)ₙ-W²-

In General Formula (XXII), W¹ and W² each independently represent a divalent cyclic alkylene group, a divalent cyclic alkenylene group, an arylene group, or a divalent heterocyclic group. L¹¹⁵ represents a single bond or a divalent linking group. n represents an integer of 1 to 4.

Examples of W¹ and W² include 1,4-cyclohexanediyl, 1,4-cyclohexenediyl, 1,4-phenylene, pyrimidine-2,5-diyl, pyridine-2,5-diyl, 1,3,4-thiadiazole-2,5-diyl, 1,3,4-oxadiazole-2,5-diyl, naphthalene-2,6-diyl, naphthalene-1,5-diyl, thiophene-2,5-diyl, and pyridazine-3,6-diyl. In a case of 1,4-cyclohexanediyl, 1,4-cyclohexanediyl may be any one isomer of structural isomers of a trans-isomer and a cis-isomer, or a mixture in which the isomers are mixed at any ratio. Among them, the trans-isomer is preferable.

W¹ and W² may each have a substituent. Examples of the substituent include groups exemplified in the aforementioned substituent group Y, and more specific examples thereof include a halogen atom (fluorine atom, chlorine atom, bromine atom, and iodine atom), a cyano group, an alkyl group having 1 to 10 carbon atoms (for example, methyl group, ethyl group, propyl group, and the like), an alkoxy group having 1 to 10 carbon atoms (for example, methoxy group, ethoxy group, and the like), an acyl group having 1 to 10 carbon atoms (for example, formyl group, acetyl group, and the like), an alkoxycarbonyl group having 1 to 10 carbon atoms (for example, methoxycarbonyl group, ethoxycarbonyl group, and the like), an acyloxy group having 1 to 10 carbon atoms (for example, acetyloxy group, propionyloxy group, and the like), a nitro group, a trifluoromethyl group, a difluoromethyl group, and the like.

In a case where there are a plurality of W¹'s, the plurality of W¹'s may be the same as or different from each other.

In General Formula (XXII), L¹¹⁵ represents a single bond or a divalent linking group. As the divalent linking group represented by L¹¹⁵, a specific example of the aforementioned divalent linking group represented by L¹¹¹ to L¹¹⁴ is exemplified, and examples thereof include -CO-O-, -O-CO-, -CH₂-O-, and -O-CH₂-.

In a case where there are a plurality of L¹¹⁵'s, the plurality of L¹¹⁵'s may be the same as or different from each other.

The preferred skeleton of the basic skeleton of the mesogenic group represented by General Formula (XXII) is illustrated below. The mesogenic groups may be substituted with substituents on these skeletons.

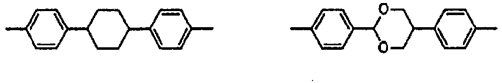

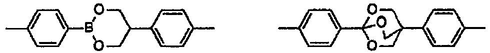

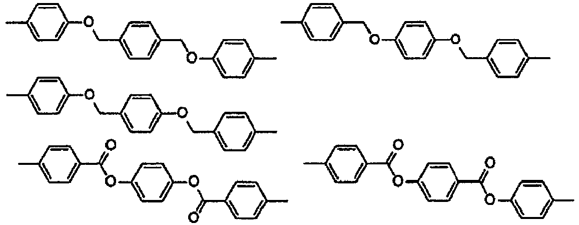

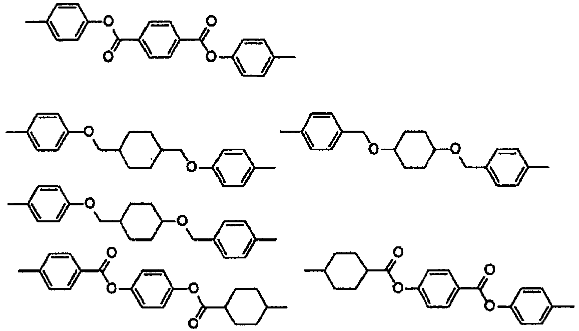

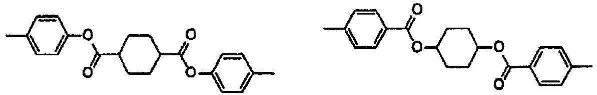

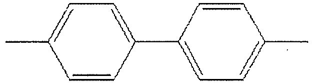

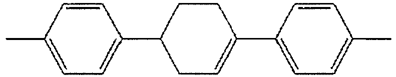

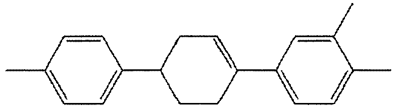

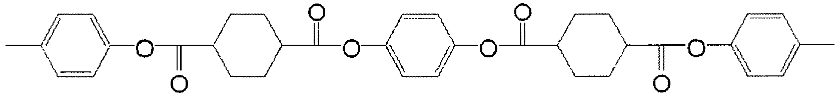

Among the skeletons, a biphenyl skeleton is preferable in that the obtained thermally conductive material has more excellent thermally conductive properties.

The compound represented by General Formula (XXI) can be synthesized by referring to the method described in JP1999-513019A (JP-H11-513019A) (WO97/00600).

The rod-like compound may be a monomer having a mesogenic group described in JP1999-323162A (JP-H11-323162A) and JP4118691B.

Among them, the rod-like compound is preferably a compound represented by General Formula (E1).

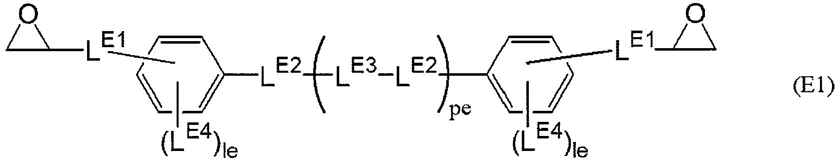

In General Formula (E1), L^{E1}'s each independently represent a single bond or a divalent linking group.

Among them, L^{E1} is preferably a divalent linking group.

The divalent linking group is preferably -O-, -S-, -CO-, -NH-, -CH=CH-, -C=C-, -CH=N-, -N=CH-, -N=N-, an alkylene group which may have a substituent, or a group obtained by combining two or more thereof, and more preferably -O-alkylene group- or -alkylene group-O-.

Moreover, the alkylene group may be any of linear, branched, or cyclic, but is preferably a linear alkylene group having 1 to 2 carbon atoms.

The plurality of L^{E1}'s may be the same as or different from each other.

In General Formula (E1), L^{E2}'s each independently represent a single bond, -CH=CH-, -CO-O-, -O-CO-, -C(-CH₃)=CH-, -CH=C(-CH₃)-, -CH=N-, -N=CH-, -N=N-, -C≡C-, -N=N⁺(-O⁻)-, -N⁺(-O⁻)=N-, -CH=N⁺(-O⁻)-, -N⁺(-O⁻)=CH-, -CH=CH-CO-, -CO-CH=CH-, -CH=C(-CN)-, or -C(-CN)=CH-.

Among them, L^{E2}'s are each independently preferably a single bond, -CO-O-, or -O-CO-.

In a case where there are a plurality of L^{E2}'s, the plurality of L^{E2}'s may be the same as or different from each other.

In General Formula (E1), L^{E3}'s each independently represent a single bond, a 5-membered or 6-membered aromatic ring group or a 5-membered or 6-membered non-aromatic ring group, which may have a substituent, or a polycyclic group consisting of these rings.

Examples of the aromatic ring group and non-aromatic ring group represented by L^{E3} include a 1,4-cyclohexanediyl group, a 1,4-cyclohexenediyl group, a 1,4-phenylene group, a pyrimidine-2,5-diyl group, a pyridine-2,5-diyl group, a 1,3,4-thiadiazole-2,5-diyl group, a 1,3,4-oxadiazole-2,5-diyl group, a naphthalene-2,6-diyl group, a naphthalene-1,5-diyl group, a thiophene-2,5-diyl group, and a pyridazine-3,6-diyl group, each of which may have a substituent. In a case of the 1,4-cyclohexanediyl group, the group may be any one isomer of structural isomers of a trans-isomer and a cis-isomer, or a mixture in which the isomers are mixed at any ratio. Among them, a trans-isomer is preferable.

Among them, L^{E3} is preferably a single bond, a 1,4-phenylene group, or a 1,4-cyclohexenediyl group.

The substituents contained in the groups represented by L^{E3} are each independently preferably an alkyl group, an alkoxy group, a halogen atom, a cyano group, a nitro group, or an acetyl group, and more preferably an alkyl group (preferably having one carbon atom).

In a case where there are a plurality of substituents, these substituents may be the same as or different from each other.

In a case where there are a plurality of L^{E3}'s, the plurality of L^{E3}'s may be the same as or different from each other.

In General Formula (E1), pe represents an integer of 0 or greater.

In a case where pe is an integer of 2 or greater, a plurality of (-L^{E3}-L^{E2}-)'s may be the same as or different from each other.

Among them, pe is preferably 0 to 2, more preferably 0 or 1, and even more preferably 0.

In General Formula (E1), L^{E4}'s each independently represent a substituent.

The substituents are each independently preferably an alkyl group, an alkoxy group, a halogen atom, a cyano group, a nitro group, or an acetyl group, and more preferably an alkyl group (preferably having one carbon atom).

A plurality of L^{E4}'s may be the same as or different from each other. In addition, in a case where le described below is an integer of 2 or greater, the plurality of L^{E4}'s present in the same (L^{E4})ₗₑ may also be the same as or different from each other.

In General Formula (E1), le's each independently represent an integer of 0 to 4.

Among them, le's are each independently preferably 0 to 2.

A plurality of le's may be the same as or different from each other.

### <Disk-like compound>

The epoxy compound, which is a disk-like compound, has a disk-like structure in at least a portion thereof.

The disk-like structure has at least an alicyclic ring or an aromatic ring. In particular, in a case where the disk-like structure has an aromatic ring, the disk-like compound can form a columnar structure by forming a stacking structure based on the intermolecular π-π interaction.

Specific examples of the disk-like structure include the triphenylene structure described in Angew. Chem. Int. Ed. 2012, 51, 7990 to 7993, or JP1995-306317A (JP-H07-306317A), and the trisubstituted benzene structures described in JP2007-2220A and JP2010-244038A.

In a case where a disk-like compound is used as the epoxy compound, a thermally conductive material exhibiting high thermally conductive properties can be obtained. The reason is that since the rod-like compound can conduct heat only linearly (one-dimensionally), whereas the disk-like compound can conduct heat planarly (two-dimensionally) in a normal direction, it is considered that the thermal conduction path increases and the thermal conductivity improves.

The disk-like compound preferably has three or more epoxy groups. The cured substance of the composition including the disk-like compound having three or more epoxy groups tends to have a high glass transition temperature and high heat resistance.

The number of epoxy groups contained in the disk-like compound is preferably 8 or less and more preferably 6 or less.

Specific examples of the disk-like compound include compounds which have at least one (preferably, three or more) of terminals as an epoxy group in the compounds or the like described in C. Destrade et al., Mol. Crysr. Liq. Cryst., vol. 71, page 111 (1981); edited by The Chemical Society of Japan, Quarterly Review of Chemistry, No. 22, Chemistry of liquid crystal, Chapter 5, Chapter 10, Section 2 (1994); B. Kohne et al., Angew. Chem. Soc. Chem. Comm., page 1794 (1985); J. Zhang et al., J. Am. Chem. Soc., vol. 116, page 2655 (1994); and JP4592225B.

Examples of the disk-like compound include compounds which have at least one (preferably, three or more) of terminals as an epoxy group in the triphenylene structures described in Angew. Chem. Int. Ed. 2012, 51, 7990 to 7993 and JP1995-305317A (JP-H07-306317A) and the trisubstituted benzene structures described in JP2007-2220A and JP2010-244038A.

As the disk-like compound, a compound represented by any of Formulae (D1) to (D16) is preferable from the viewpoint of more excellent thermally conductive properties of the thermally conductive material.

First, Formulae (D1) to (D15) will be described, and then Formula (D16) will be described.

In the following formulae, "-LQ" represents "-L-Q", and "QL-" represents "Q-L-".

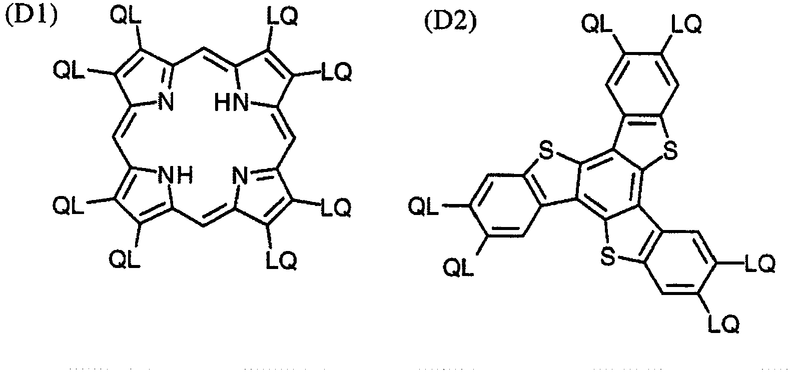

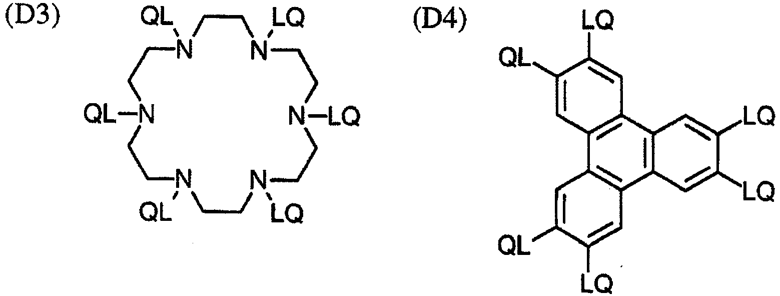

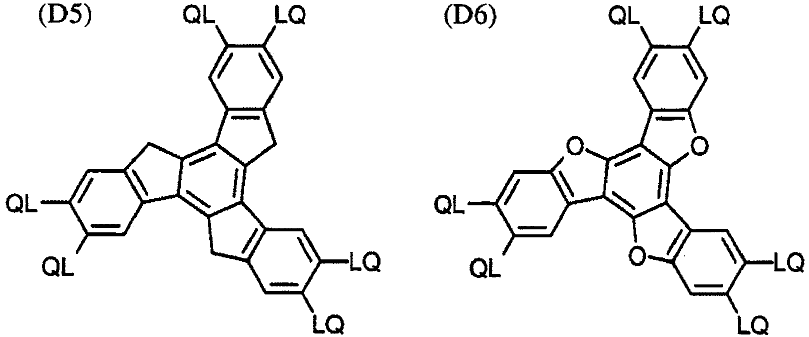

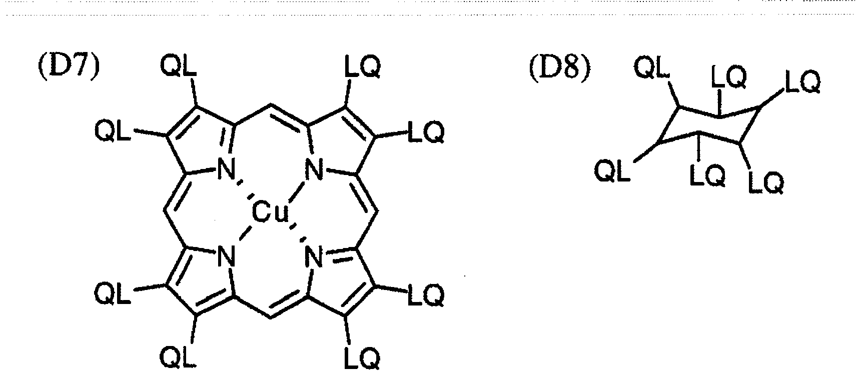

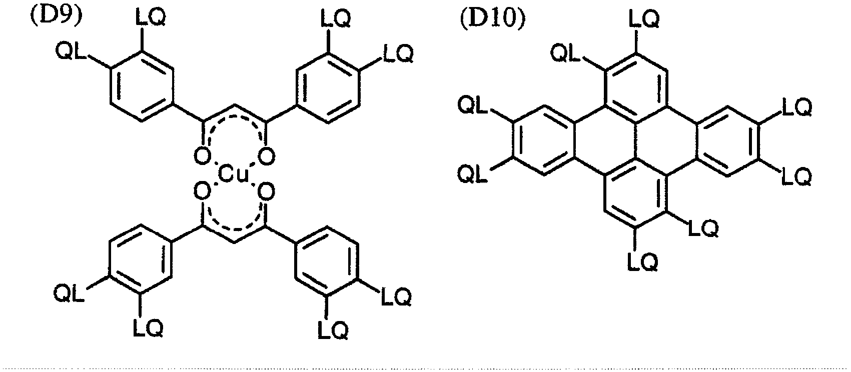

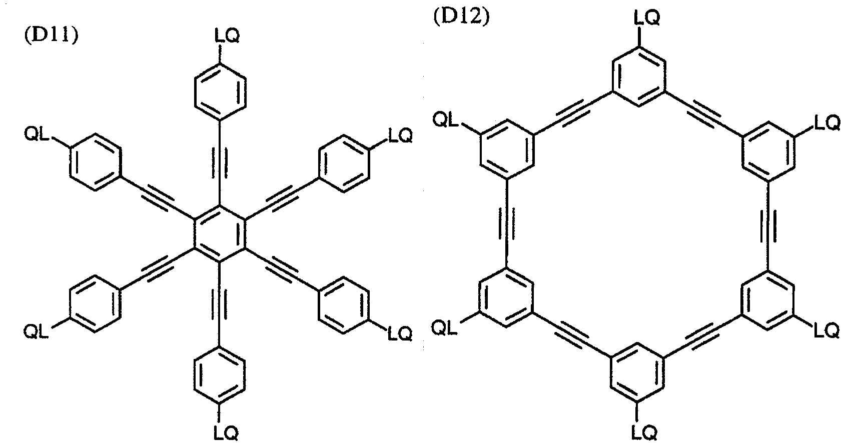

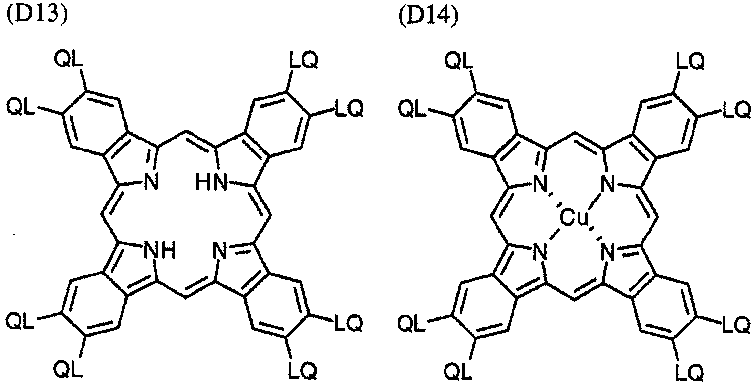

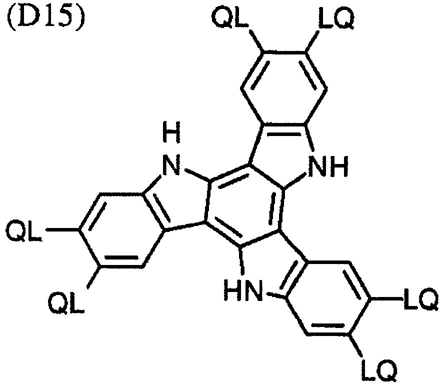

In Formulae (D1) to (D15), L represents a divalent linking group.

From the viewpoint of more excellent thermally conductive properties of the thermally conductive material, L is each independently preferably an alkylene group, an alkenylene group, an arylene group, and a group selected from the group consisting of -CO-, -NH-, -O-, -S-, and a combination thereof, and more preferably an alkylene group, an alkenylene group, an arylene group, and a group obtained by combining two or more groups selected from the group consisting of -CO-, -NH-, -O-, and -S-.

The number of carbon atoms in the alkylene group is preferably 1 to 12. The number of carbon atoms in the alkenylene group is preferably 2 to 12. The number of carbon atoms in the arylene group is preferably 10 or less.

The alkylene group, the alkenylene group, and the arylene group may have a substituent (preferably, an alkyl group, a halogen atom, a cyano group, an alkoxy group, an acyloxy group, and the like).

An example of L is shown below. In the following example, a bonding site on the left side is bonded to a central structure of the compound represented by any of Formulae (D1) to (D15) (hereinafter, also simply referred to as "central ring"), and a bonding site on the right side is bonded to Q.

AL means an alkylene group or an alkenylene group, and AR means an arylene group.
L101: -AL-CO-O-AL-
L102: -AL-CO-O-AL-O-
L103: -AL-CO-O-AL-O-AL-
L104: -AL-CO-O-AL-O-CO-
L105: -CO-AR-O-AL-
L106: -CO-AR-O-AL-O-
L107: -CO-AR-O-AL-O-CO-
L108: -CO-NH-AL-
L109: -NH-AL-O-
L110: -NH-AL-O-CO-
L111: -O-AL-
L112: -O-AL-O-
L113: -O-AL-O-CO-
L114: -O-AL-O-CO-NH-AL-
L115: -O-AL-S-AL-
L116: -O-CO-AL-AR-O-AL-O-CO-
L117: -O-CO-AR-O-AL-CO-
L118: -O-CO-AR-O-AL-O-CO-
L119: -O-CO-AR-O-AL-O-AL-O-CO-
L120: -O-CO-AR-O-AL-O-AL-O-AL-O-CO-
L121: -S-AL-
L122: -S-AL-O-
L123: -S-AL-O-CO-
L124: -S-AL-S-AL-
L125: -S-AR-AL-
L126: -O-CO-AL-
L127: -O-CO-AL-O-
L128: -O-CO-AR-O-AL-
L129: -O-CO-
L130: -O-CO-AR-O-AL-O-CO-AL-S-AR-
L131: -O-CO-AL-S-AR-
L132: -O-CO-AR-O-AL-O-CO-AL-S-AL-
L133: -O-CO-AL-S-AR-
L134: -O-AL-S-AR-
L135: -AL-CO-O-AL-O-CO-AL-S-AR-
L136: -AL-CO-O-AL-O-CO-AL-S-AL-
L137: -O-AL-O-AR-
L138: -O-AL-O-CO-AR-
L139: -O-AL-NH-AR-
L140: -O-CO-AL-O-AR-
L141: -O-CO-AR-O-AL-O-AR-
L142: -AL-CO-O-AR-
L143: -AL-CO-O-AL-O-AR-

In Formulae (D1) to (D15), Q each independently represents a hydrogen atom or a substituent.

Examples of the substituent include groups exemplified in the aforementioned substituent group Y More specifically, examples of the substituent include the aforementioned reactive functional group, a halogen atom, an isocyanate group, a cyano group, an unsaturated polymerizable group, an epoxy group, an oxetanyl group, an aziridinyl group, a thioisocyanate group, an aldehyde group, a sulfo group, and the like.

However, in a case where Q is a group other than the epoxy group, Q is preferably stable with respect to the epoxy group.

In Formulae (D1) to (D15), one or more (preferably two or more) Qs represent an epoxy group. Among them, it is preferable that all Qs represent epoxy groups from the viewpoint of more excellent thermally conductive properties of the thermally conductive material.

The compounds represented by Formulae (D1) to (D15) preferably do not have -NH-from the viewpoint of the stability of the epoxy group.

Among the compounds represented by Formulae (D1) to (D15), the compound represented by Formula (D4) is preferable from the viewpoint of more excellent thermally conductive properties of the thermally conductive material. In other words, the central ring of the disk-like compound is preferably a triphenylene ring.

As the compound represented by Formula (D4), the compound represented by Formula (XI) is preferable from the viewpoint of more excellent thermally conductive properties of the thermally conductive material.

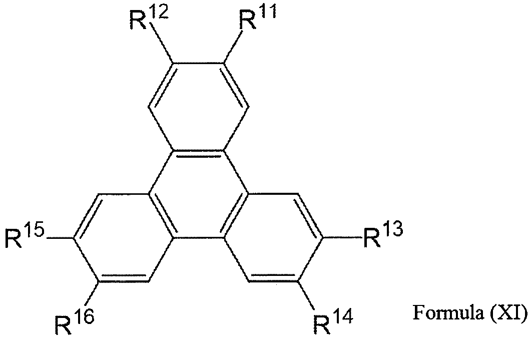

In Formula (XI), R¹¹, R¹², R¹³, R¹⁴, R¹⁵, and R¹⁶ each independently represent ^{∗}-X¹¹-L¹¹-P¹¹ or ^{∗}-X¹²-L¹²-Y¹².

^{∗} represents the bonding position with a triphenylene ring.

Among R¹¹, R¹², R¹³, R¹⁴, R¹⁵, and R¹⁶, two or more are preferably ^{∗}-X¹¹-L¹¹-P¹¹, and three or more are preferably ^{∗}-X¹¹-L¹¹-P¹¹.

Among them, from the viewpoint of more excellent thermally conductive properties of the thermally conductive material, one or more of R¹¹ or R¹², one or more of R¹³ or R¹⁴, and one or more of R¹⁵ or R¹⁶ are preferably ^{∗}-X¹¹-L¹¹-P¹¹.

It is more preferable that R¹¹, R¹², R¹³, R¹⁴, R¹⁵, and R¹⁶ are all ^{∗}-X¹¹-L¹¹-P¹¹. In addition, it is more preferable that R¹¹, R¹², R¹³, R¹⁴, R¹⁵, and R¹⁶ are all the same.

X¹¹ each independently represents a single bond, -O-, -CO-, -NH-, -O-CO-, -O-CO-O-, -O-CO-NH-, -O-CO-S-, -CO-O-, -CO-NH-, -CO-S-, -NH-CO-, -NH-CO-O-, -NH-CO-NH-, -NH-CO-S-, -S-, -S-CO-, -S-CO-O-, -S-CO-NH-, or -S-CO-S-.

Among them, X¹¹ is each independently preferably -O-, -O-CO-, -O-CO-O-, -O-CO-NH-, -CO-O-, -CO-NH-, -NH-CO-, or -NH-CO-O-, and more preferably -O-, -O-CO-, -CO-O-, -O-CO-NH-, or -CO-NH-, and even more preferably -O-CO- or -CO-O-.

L¹¹ each independently represents a single bond or a divalent linking group.

Examples of the divalent linking group, include -O-, -O-CO-, -CO-O-, -S-, -NH-, an alkylene group (the number of carbon atoms is preferably 1 to 10, more preferably 1 to 8, and even more preferably 1 to 7), an arylene group (the number of carbon atoms is preferably 6 to 20, more preferably 6 to 14, and even more preferably 6 to 10), or a group obtained by combining these groups.

Examples of the alkylene group include a methylene group, an ethylene group, a propylene group, a butylene group, a pentylene group, a hexylene group, and a heptylene group.

Examples of the arylene group include a 1,4-phenylene group, a 1,3-phenylene group, a 1,4-naphthylene group, a 1,5-naphthylene group, and an anthrasenylene group, and a 1,4-phenylene group is preferable.

The alkylene group and the arylene group may each have a substituent. The number of substituents is preferably 1 to 3, and more preferably 1. The substitution position of the substituent is not particularly limited. As the substituent, a halogen atom or an alkyl group having 1 to 3 carbon atoms is preferable, and a methyl group is more preferable.

It is also preferable that the alkylene group and the arylene group are unsubstituted. Among them, the alkylene group is preferably unsubstituted.

Examples of -X¹¹-L¹¹- include L101 to L143, which are examples of the aforementioned L.

P¹¹ represents an epoxy group. The epoxy group may or may not have a substituent, if possible.

X¹² is the same as X¹¹, and the preferred conditions are also the same.

L¹² is the same as L¹¹, and the preferred conditions are also the same.

Examples of -X¹²-L¹²- include L101 to L143, which are examples of the aforementioned L.

Y¹² represents a group in which one or two or more methylene groups in a hydrogen atom, a linear, branched, or cyclic alkyl group having 1 to 20 carbon atoms, or a linear, branched, or cyclic alkyl group having 1 to 20 carbon atoms are substituted with -O-, -S-, -NH-, -N (CH₃)-, -CO-, -O-CO-, or -CO-O-.

In a case where in Y¹², one or two or more methylene groups in a linear, branched, or cyclic alkyl group having 1 to 20 carbon atoms, or a linear, branched, or cyclic alkyl group having 1 to 20 carbon atoms are groups substituted with -O-, -S-, -NH-, -N(CH₃)-, -CO-, -O-CO-, or -CO-O-, one or more of the hydrogen atoms contained in Y¹² may be substituted with halogen atoms.

Specific examples of the compound represented by Formula (XI) include a compound in which at least one (preferably three or more) of terminals is an epoxy group in the compound described in paragraphs 0028 to 0036 of JP1995-281028A (JP-H07-281028A), JP1995-306317A (JP-H07-306317A), paragraphs 0016 to 0018 of JP2005-156822A, paragraphs 0067 to 0072 of JP2006-301614A, and pages 330 to 333 of Handbook of Liquid Crystals (published by Maruzen Co., Ltd., 2000).

The compound represented by Formula (XI) can be synthesized in accordance with the methods described in JP1995-306317A (JP-H07-306317A), JP1995-281028A (JP-H07-281028A), JP2005-156822A, and JP2006-301614A.

In addition, from the viewpoint of more excellent thermally conductive properties of the thermally conductive material, the compound represented by Formula (D16) is also preferable as the disk-like compound.

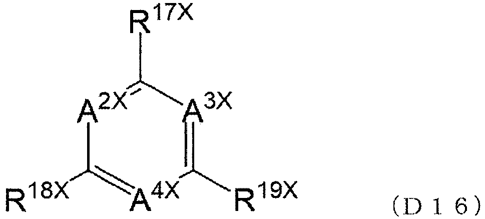

In Formula (D16), A^{2X}, A^{3X}, and A^{4X} each independently represent -CH= or -N=. Among them, A^{2X}, A^{3X}, and A^{4X} each independently preferably represent -CH=.

R^{17X}, R^{18X}, and R^{19X} each independently represent ^{∗}-X^{211X}-(Z^{21X}-X^{212X})_{n21X}-L^{21X}-Q. ^{∗} represents a bonding position with a central ring.

X^{211X} and X^{212X} each independently represent a single bond, -O-, -CO-, -NH-, -O-CO-, -O-CO-O-, -O-CO-NH-, -O-CO-S-, -CO-O-, -CO-NH-, -CO-S-, -NH-CO-, -NH-CO-O-, -NH-CO-NH-, -NH-CO-S -, -S-, -S-CO-, -S-CO-O-, -S-CO-NH-, or -S-CO-S-.

Z^{21X} each independently represents a 5-membered or 6-membered aromatic ring group or a 5-membered or 6-membered non-aromatic ring group.

L^{21x} represents a single bond or a divalent linking group.

Q is synonymous with Q in Formulae (D1) to (D15), and the preferable conditions are also the same. In Formula (D16), at least one (preferably all) Q among the plurality of Qs represents an epoxy group.

n21X represents an integer of 0 to 3. In a case where n21X is 2 or greater, a plurality of (Z^{21X}-X^{212X}) may be the same or different.

However, the compound represented by Formula (D16) preferably does not have -NH- from the viewpoint of the stability of the epoxy group.

As the compound represented by Formula (D16), the compound represented by Formula (XII) is preferable.

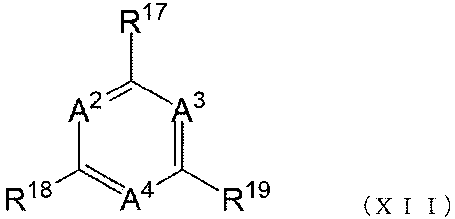

In Formula (XII), A², A³, and A⁴ each independently represent -CH= or -N=. Among them, A², A³, and A⁴ are preferably -CH=. In other words, it is also preferable that the central ring of the disk-like compound is a benzene ring.

R¹⁷, R¹⁸, and R¹⁹ each independently represent ^{∗}-X²¹¹- (Z²¹-X²¹²)ₙ₂₁-L²¹-P²¹ or ^{∗}-X²²¹-(Z²²-X²²²)ₙ₂₂-Y²². ^{∗} represents a bonding position with a central ring.

Two or more of R¹⁷, R¹⁸, and R¹⁹ are ^{∗}-X²¹¹- (Z²¹-X²¹²) ₙ₂₁-L²¹-P²¹. From the viewpoint of more excellent thermally conductive properties of the thermally conductive material, it is preferable that all of R¹⁷, R¹⁸, and R¹⁹ are ^{∗}-X²¹¹- (Z²¹-X²¹²) n21-L²¹-P²¹.

In addition, it is preferable that R¹⁷, R¹⁸, and R¹⁹ are all the same.

X²¹¹, X²¹², X²²¹, and X²²² each independently represent a single bond, -O-, -CO-, -NH-, -O-CO-, -O-CO-O-, -O-CO-NH-, -O-CO-S-, -CO-O-, -CO-NH-, -CO-S-, -NH-CO-, -NH-CO-O-, -NH-CO-NH-, -NH-CO-S-, -S-, -S-CO-, -S-CO-O-, -S-CO-NH-, or -S-CO-S-.

Among them, X²¹¹, X²¹², X²²¹, and X²²² are each independently preferably a single bond, -O-, -CO-O-, or -O-CO-.

Z²¹ and Z²² each independently represent a 5-membered or 6-membered aromatic ring group, or a 5-membered or 6-membered non-aromatic ring group, and examples thereof include a 1,4-phenylene group, a 1,3-phenylene group, and an aromatic heterocyclic group.

The aromatic ring group and the non-aromatic ring group may have a substituent. The number of substituents is preferably 1 or 2, more preferably 1. The substitution position of the substituent is not particularly limited. As the substituent, a halogen atom or a methyl group is preferable. It is also preferable that the aromatic ring group and the non-aromatic ring group are unsubstituted.

Examples of the aromatic heterocyclic group include the following aromatic heterocyclic groups.

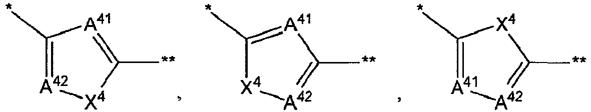

In the formula, ^{∗} represents a site that is bonded to X²¹¹ or X²²¹. ^{∗∗} represents a site that is bonded to X²¹² or X²²². A⁴¹ and A⁴² each independently represent a methine group or a nitrogen atom. X⁴ represents an oxygen atom, a sulfur atom, a methylene group, or an imino group.

Preferably at least one of A⁴¹ or A⁴² is a nitrogen atom, and more preferably both of A⁴¹ and A⁴² are nitrogen atoms. In addition, X⁴ is preferably an oxygen atom.

In a case where n21 and n22 to be described later are two or greater, a plurality of (Z²¹-X²¹²) and (Z²²-X²²²) may be the same or different, respectively.

L²¹ each independently represents a single bond or a divalent linking group, and is synonymous with L¹¹ in the aforementioned Formula (XI). L²¹ is preferably -O-, -O-CO-, -CO-O-, -S-, -NH-, and an alkylene group (the number of carbon atoms is preferably 1 to 10, more preferably 1 to 8, and even more preferably 1 to 7), an arylene group (the number of carbon atoms is preferably 6 to 20, more preferably 6 to 14, and even more preferably 6 to 10), or a group obtained by combining these.

In a case where n22 to be described later is 1 or greater, examples of -X²¹²-L²¹-similarly include L101 to L143, which are examples of L in the aforementioned Formulae (D1) to (D15).

P²¹ represents an epoxy group. The epoxy group may or may not have a substituent, if possible.

Y²² each independently represents a group in which one or two or more methylene groups in a hydrogen atom, a linear, branched, or cyclic alkyl group having 1 to 20 carbon atoms, or a linear, branched, or cyclic alkyl group having 1 to 20 carbon atoms are substituted with -O-, -S-, -NH-, -N (CH₃)-, -CO-, -O-CO-, or -CO-O-, and is synonymous with Y¹² in General Formula (XI), and the preferred range is also the same.

n21 and n22 each independently represent an integer of 0 to 3, and from the viewpoint of more excellent thermally conductive properties, preferably an integer of 1 to 3, and more preferably an integer of 2 to 3.

Preferred examples of the disk-like compound include the following compounds.

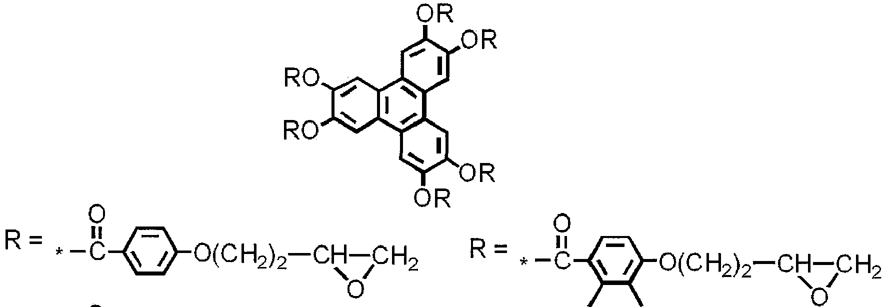

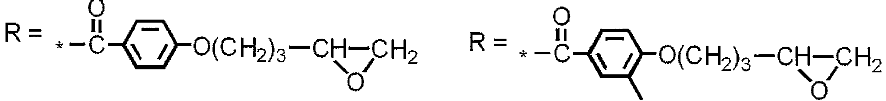

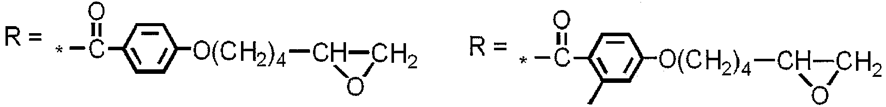

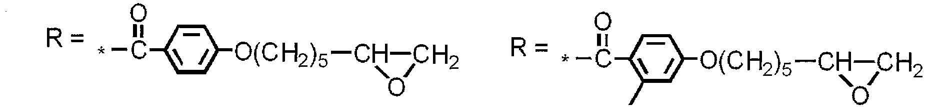

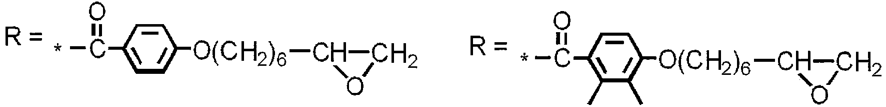

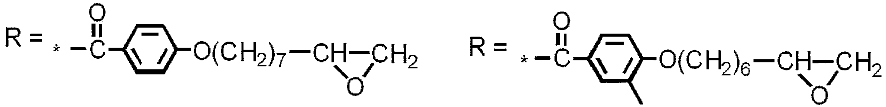

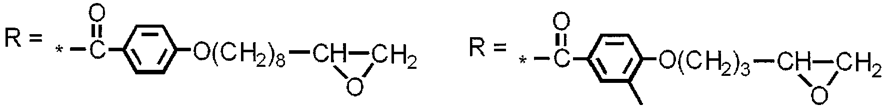

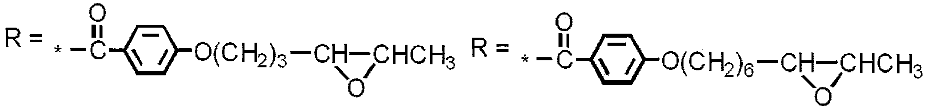

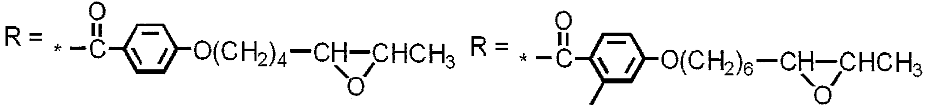

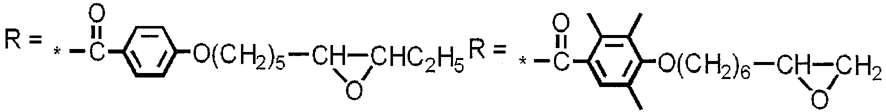

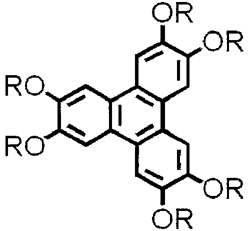

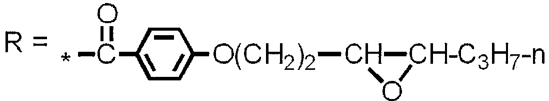

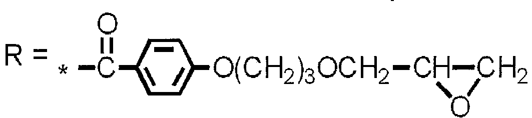

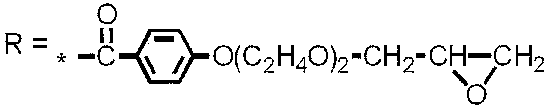

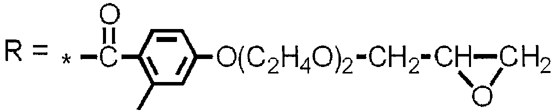

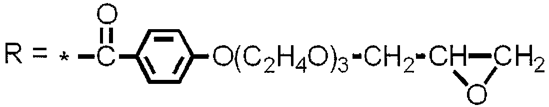

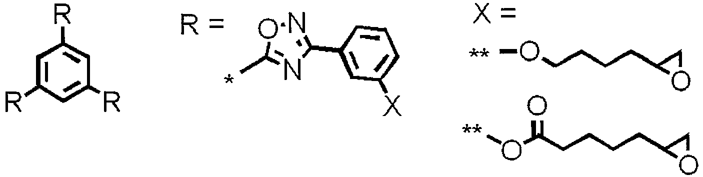

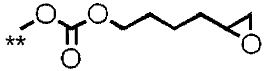

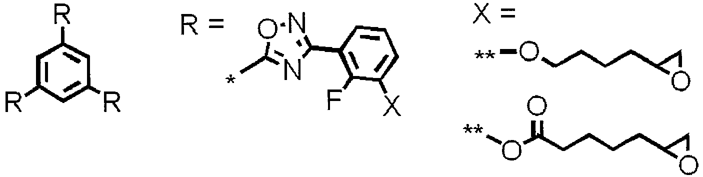

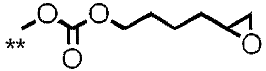

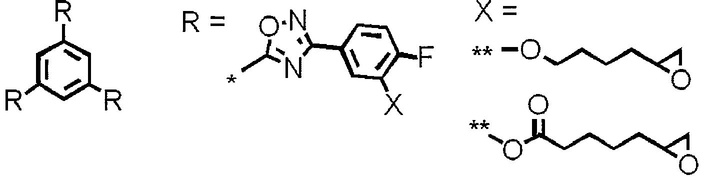

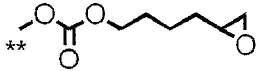

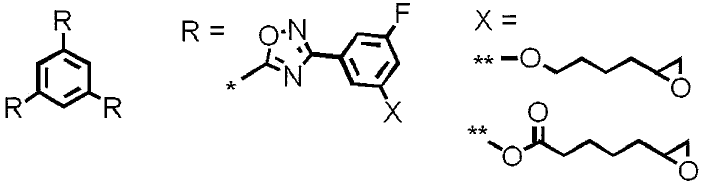

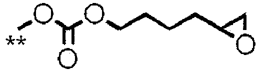

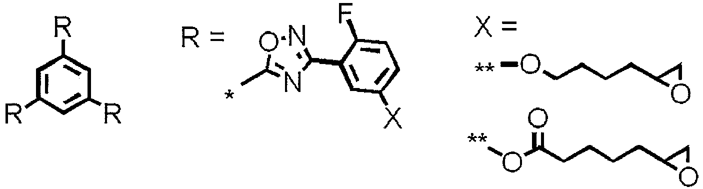

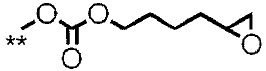

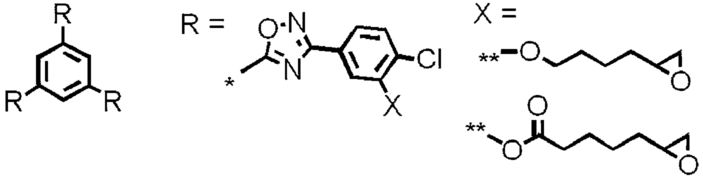

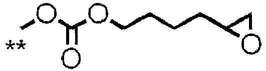

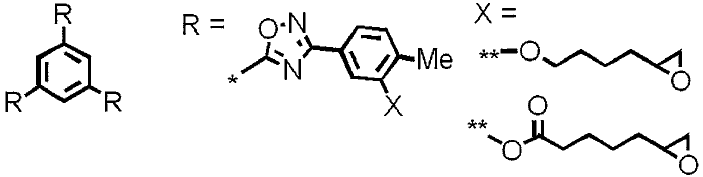

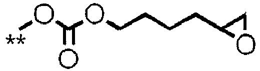

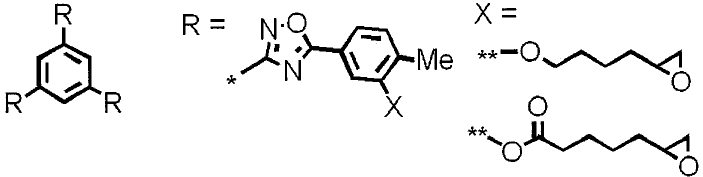

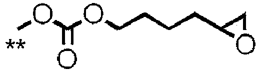

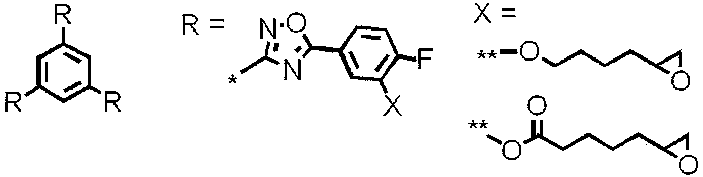

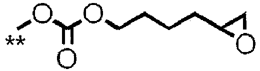

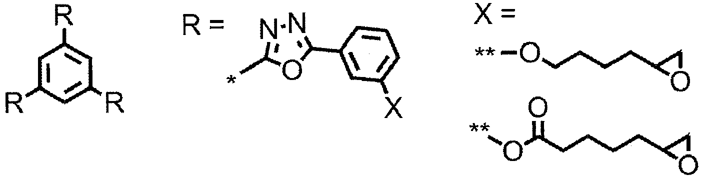

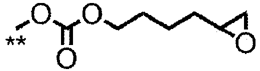

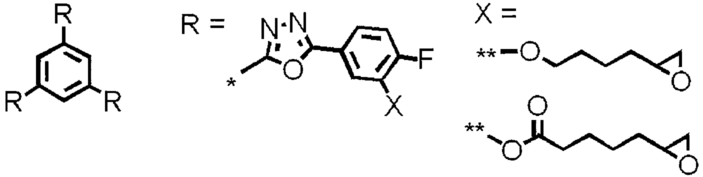

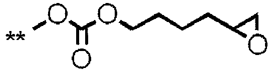

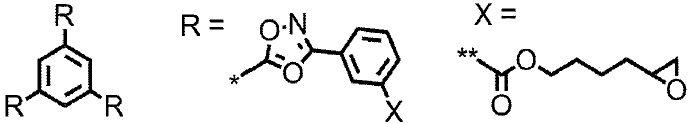

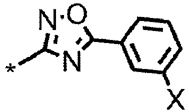

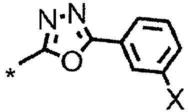

In the following structural formula, R represents -X²¹²-L²¹-P²¹.

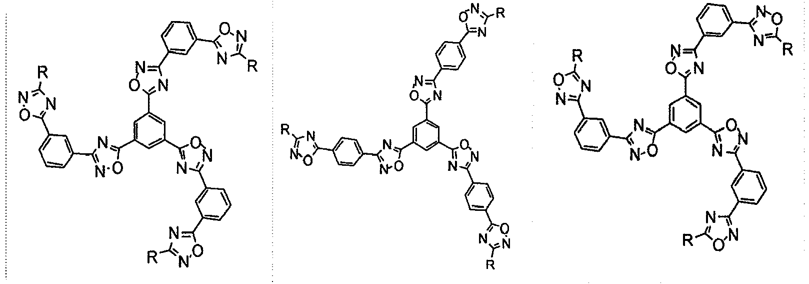

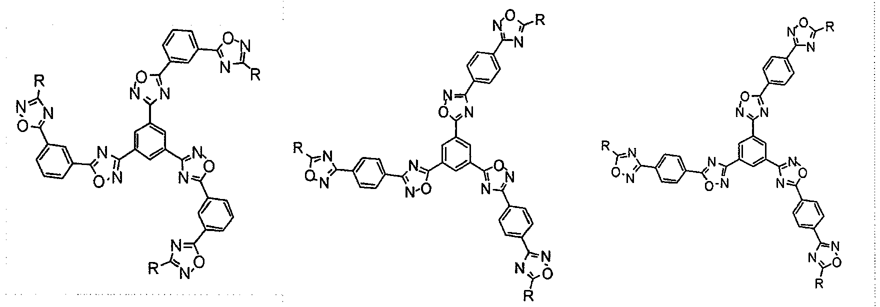

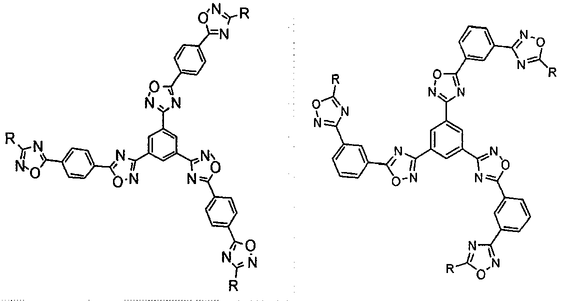

For details and specific examples of the compound represented by Formula (XII), a compound in which at least one (preferably three or more) of terminals in the compounds described in paragraphs 0013 to 0077 of JP2010-24403 8A is an epoxy group can be referred to, and the content is incorporated in the present specification.

The compound represented by Formula (XII) can be synthesized in accordance with the methods described in JP2010-244038A, JP2006-76992A, and JP2007-2220A.

The disk-like compound is preferably a compound having a hydrogen-bonding functional group from the viewpoint of reducing the electron density, strengthening the stacking, and facilitating the formation of a columnar aggregate. Examples of the hydrogen-bonding functional group include -O-CO-NH-, -CO-NH-, -NH-CO-, -NH-CO-O-, -NH-CO-NH-, -NH-CO-S-, or -S-CO-NH-.

### <Other epoxy compounds>

Examples of epoxy compounds other than the aforementioned epoxy compound include an epoxy compound represented by General Formula (DN).

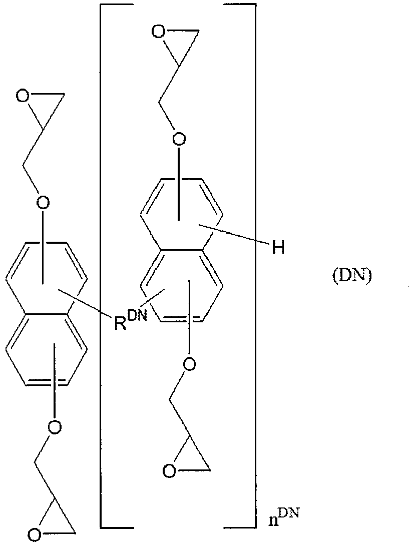

In General Formula (DN), n^{DN} represents an integer of 0 or greater, preferably 0 to 5, and more preferably 1.

R^{DN} represents a single bond or a divalent linking group. The divalent linking group is preferably -O-, -O-CO-, -CO-O-, -S-, an alkylene group (the number of carbon atoms is preferably 1 to 10), an arylene group (the number of carbon atoms is preferably 6 to 20), or a group obtained by combining these groups, more preferably an alkylene group, and even more preferably a methylene group.

Examples of the other epoxy compounds include, in addition to the aforementioned epoxy compounds, a bisphenol A-type epoxy compound (compound in which in General Formula (E1), "pe = 0" and "L^{E2} is -C(CH₃)₂-", or the like), a bisphenol F-type epoxy compound (compound in which in General Formula (E1), "pe = 0" and "L^{E2} is -CH₂-", or the like), a bisphenol S-type epoxy compound, a bisphenol AD-type epoxy compound, and the like, which are glycidyl ethers of bisphenol A, F, S, and AD, and the like; a hydrogenated bisphenol A-type epoxy compound, a hydrogenated bisphenol AD-type epoxy compound, and the like; a phenol novolac-type glycidyl ether (phenol novolac-type epoxy compound), a cresol novolac-type glycidyl ether (cresol novolac-type epoxy compound), a bisphenol A novolac-type glycidyl ether, and the like; a dicyclopentadiene-type glycidyl ether (dicyclopentadiene-type epoxy compound); a dihydroxypentadiene-type glycidyl ether (dihydroxypentadiene-type epoxy compound); a polyhydroxybenzene-type glycidyl ether (polyhydroxybenzene-type epoxy compound); a benzene polycarboxylic acid-type glycidyl ester (benzene polycarboxylic acid-type epoxy compound); an alicyclic epoxy compound such as 3,4: 8,9-diepoxybicyclo[4.3.0]nonane, and a trisphenol methane-type epoxy compound. In addition, resorcinol diglycidyl ether and the like can also be used.

The epoxy compound is a compound represented by any of General formulae (B01) to (B03) in a surface modifier for inorganic nitride described later, and is preferably different from a compound having one or more epoxy groups (compound represented by any of General Formulae (B01) to (B03) having an epoxy group).

One kind of the epoxy compounds may be used singly, or two or more kinds thereof may be used.

In a case where the composition contains compound X1 containing an acid anhydride group, a cyanate ester group, an amino group, a thiol group, or a carboxylic acid group as a specific functional group, in a ratio of a content of the epoxy compound to a total content of the compound X1 and an optionally contained curing agent (for example, phenolic compound described later), an equivalent ratio (number of epoxy group/number of functional group capable of reacting with epoxy group) of the epoxy group of the epoxy compound in the compound X1 to a functional group capable of reacting with the epoxy group and a functional group capable of reacting with the epoxy group in the optionally contained curing agent is preferably an amount of 30/70 to 70/30, more preferably an amount of 35/65 to 65/35, and even more preferably an amount of 40/60 to 60/40.

Examples of the functional group capable of reacting with the epoxy group in the compound X1 include an acid anhydride group, a cyanate ester group, and active hydrogen contained in an amino group, a thiol group, and a carboxylic acid group. In addition, in a case where the curing agent is a phenolic compound described later, examples of the functional group capable of reacting with the epoxy group in the phenolic compound include a hydroxyl group.

In addition, in a case where the composition contains a phenolic compound, in a ratio of the content of the epoxy compound to the content of the phenolic compound in the composition is an equivalent ratio of the epoxy group of the epoxy compound to the hydroxyl group of the phenolic compound (the number of epoxy group/the number of hydroxyl group) is preferably an amount of 30/70 to 70/30, more preferably an amount of 40/60 to 60/40, and even more preferably an amount of 45/55 to 55/45.

In addition, in a case where the composition contains a phenolic compound, a total content of the epoxy compound to the phenolic compound in the composition is preferably 5% to 90% by mass, more preferably 10% to 50% by mass, and even more preferably 10% to 40% by mass with respect to a total solid content of the composition.

In addition, in this specification, "total solid content" is intended to mean a component forming a thermally conductive material, and does not contain a solvent. The component for forming a thermally conductive material here may be a component whose chemical structure changes by reacting (polymerizing) at a time of forming the thermally conductive material. In addition, in a case where the component is a component for forming a thermally conductive material, even if properties thereof is liquid, the component is regarded as a solid content.

### [Inorganic substance]

The composition according to the embodiment of the present invention contains an inorganic substance.

As the inorganic substance, for example, any inorganic substances, which are used in an inorganic filler of a thermally conductive material in the related art, may be used. The inorganic substance preferably contains an inorganic nitride or an inorganic oxide, and more preferably contains an inorganic nitride, from the viewpoint of more excellent thermally conductive properties and insulating properties of the thermally conductive material.

A shape of the inorganic substance is not particularly limited, and may be a granule shape, may be a film shape, or may be a plate shape. Examples of the shape of the granular inorganic substance include a rice grain shape, a spherical shape, a cubical shape, a spindle shape, a scale shape, an aggregation shape, and an amorphous shape.

Examples of the inorganic oxide include zirconium oxide (ZrO₂), titanium oxide (TiO₂), silicon oxide (SiO₂), aluminum oxide (Al₂O₃), iron oxide (Fe₂O₃, FeO, or Fe3O₄), copper oxide (CuO or Cu₂O), zinc oxide (ZnO), yttrium oxide (Y₂O₃), niobium oxide (Nb₂O₅), molybdenum oxide (MoO₃), indium oxide (In₂O₃ or In₂O), tin oxide (SnO₂), tantalum oxide (Ta₂O₅), tungsten oxide (WO₃ or W₂O₅), lead oxide (PbO or PbO₂), bismuth oxide (Bi₂O₃), cerium oxide (CeO₂ or Ce₂O₃), antimony oxide (Sb₂O₃ or Sb₂O₅), germanium oxide (GeO₂ or GeO), lanthanum oxide (La₂O₃), ruthenium oxide (RuO₂), and the like.

Only one kind of inorganic oxides may be used, or two or more kinds thereof may be used.

The inorganic oxide is preferably titanium oxide, aluminum oxide, or zinc oxide, and more preferably aluminum oxide.

The inorganic oxide may be an oxide which is produced by oxidizing a metal prepared as a nonoxide in an environment or the like.

Examples of the inorganic nitride include boron nitride (BN), carbon nitride (C₃N₄), silicon nitride (Si₃N₄), gallium nitride (GaN), indium nitride (InN), aluminum nitride (AlN), chromium nitride (Cr₂N), copper nitride (Cu₃N), iron nitride (Fe₄N), iron nitride (Fe₃N), lanthanum nitride (LaN), lithium nitride (Li₃N), magnesium nitride (Mg₃N₂), molybdenum nitride (Mo₂N), niobium nitride (NbN), tantalum nitride (TaN), titanium nitride (TiN), tungsten nitride (W₂N), tungsten nitride (WN₂), yttrium nitride (YN), zirconium nitride (ZrN), and the like.

The inorganic nitride preferably contains an aluminum atom, a boron atom, or a silicon atom, more preferably contains aluminum nitride, boron nitride, or silicon nitride, even more preferably contains aluminum nitride or boron nitride, and particularly preferably contains boron nitride.

Only one kind of inorganic nitrides may be used, or two or more kinds thereof may be used.

A size of the inorganic substance is not particularly limited, but from the viewpoint that the dispersibility of the inorganic substance is superior, an average particle diameter of the inorganic substance is preferably 500 µm or less, more preferably 300 µm or less, and even more preferably 200 µm or less. A lower limit thereof is not particularly limited, but is preferably 10 nm or greater and more preferably 100 nm or greater, from the viewpoint of handleability.

For an average particle diameter of the inorganic substances, in a case where a commercially available product is used, a value listed in the catalog is adopted. In a case where a value is not listed in the catalog, the average particle diameter is obtained by randomly selecting 100 pieces of inorganic substances using an electron microscope, measuring particle diameters (long diameter) of the respective inorganic substances, and determining the arithmetic mean thereof.

Only one kind of inorganic substances may be used, or two or more kinds thereof may be used.

The inorganic substance preferably includes at least one of an inorganic nitride or an inorganic oxide, and more preferably includes at least an inorganic nitride.

The inorganic nitride preferably includes at least one of boron nitride or aluminum nitride, and more preferably includes at least boron nitride.

A content of the inorganic nitride (preferably boron nitride) in the inorganic substance is preferably 10% by mass or greater, more preferably 50% by mass or greater, and even more preferably 80% by mass or greater, with respect to a total mass of the inorganic substance. An upper limit thereof is 100% by mass or less.

The inorganic oxide is preferably aluminum oxide.

From the viewpoint that the thermally conductive properties of the thermally conductive material are superior, the composition more preferably contains at least inorganic substances having an average particle diameter of 20 µm or greater (preferably, 40 µm or greater).

A content of the inorganic substance in the composition is 10% by mass or greater, preferably 40% by mass or greater, more preferably 50% by mass or greater, and even more preferably 60% by mass or greater, with respect to the total solid content of the composition. The upper limit value is not particularly limited, but is preferably 95% by mass or less.

### [Compound X]

The composition according to the embodiment of the present invention comprises a compound X.

The compound X is a compound (compound X1) having one or more functional groups selected from the group consisting of an alkenyl group, an acrylate group, a methacrylate group, a silyl group, an acid anhydride group, a cyanate ester group, an amino group, a thiol group, and a carboxylic acid group (hereinafter, referred to as "specific functional group"), or a compound (compound X2) having a polyamic acid structure.

In the following, a compound X1 and a compound X2 will be described in detail.

### <Compound X1>

The compound X1 contains a specific functional group selected from the group consisting of an alkenyl group, an acrylate group (-O-CO-CH = CH2), a methacrylate group (-O-CO-C(CH₃) = CH₂), a silyl group, an acid anhydride group, a cyanate ester group (-O-CN), an amino group, thiol group (-SH), and carboxylic acid group (-COOH).

A number of the specific functional groups contained in the compound X1 is not particularly limited as long as it is 1 or more, but 2 or more is preferable.

In addition, the compound X1 may be a low molecular weight compound or a high molecular weight compound.

The molecular weight of the compound X1 is not particularly limited, and examples thereof include 50 to 100,000, preferably 100 to 100,000. In a case where the compound X1 is a polymer compound, the molecular weight is intended to have a weight average molecular weight, and is preferably 1,000 to 50,000.

The alkenyl group is preferably linear or branched. In addition, the number of carbon atoms of the alkenyl group is not particularly limited, but is preferably 2 to 8.

Examples of the alkenyl group include a vinyl group, an allyl group, a propenyl group, an isopropenyl group, a butenyl group, a hexenyl group, a cyclohexenyl group, and the like, and a vinyl group or an allyl group is preferable, and a vinyl group is more preferable.

In a case where a vinyl group as the alkenyl group is contained in the compound X1 as a specific functional group, the atomic group bonded to the vinyl group is preferably not -COO- .

The silyl group is not particularly limited, but a hydrolyzable silyl group is preferable, and for example, a hydrolyzable silyl group represented by General Formula (A) is more preferable.

-Si(R^{A1})ₚ(OR^{A2})₃₋ₚ (A)

In the formula, R^{A1} represents a substituted or unsubstituted monovalent hydrocarbon group. R^{A2} represents a hydrogen atom or a substituted or unsubstituted monovalent hydrocarbon group. p represents an integer of 0 to 2. In a case where a plurality of R^{A1}s and R^{A2}s are present, the plurality of R^{A1}s and the plurality of R^{A2}s may be the same as or different from each other.

Examples of the substituted or unsubstituted monovalent hydrocarbon groups represented by R^{A1}s and R^{A2}s include an alkyl group, an aryl group, an aralkyl group, and the like.

The alkyl group may be any of linear, branched, or cyclic.

The number of carbon atoms in the alkyl group is, for example, 1 to 12, preferably 1 to 4, and more preferably 1 or 2.

Examples of the alkyl group include a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group, a dodecyl group, a cyclopentyl group, a cyclohexyl group, a cycloheptyl group, and the like.

The number of carbon atoms of the aryl group is, for example, 6 to 12. The aryl group may be monocyclic or polycyclic.

Examples of the aryl group include a phenyl group, a naphthyl group, and the like.

In the aralkyl group, one of the hydrogen atoms of the alkyl group is substituted with an aryl group, and the alkyl group moiety may be any of linear, branched, or cyclic.

The preferred aspect of the alkyl group moiety in the aralkyl group is the same as that of the alkyl group, and the preferred aspect of the aryl group moiety is the same as that of the aryl group.

Examples of the aralkyl group include a benzyl group, a phenylethyl group, a phenylpropyl group, and the like.

The substituted or unsubstituted monovalent hydrocarbon group represented by R^{A1} and R^{A2} may further have a substituent. Examples of the substituent include the groups exemplified in the aforementioned substituent group Y, and an alkyl group and a phenyl group are preferable.

The acid anhydride group is not particularly limited, but examples thereof include a group obtained by removing any of one to two (preferably one) hydrogen atoms from acid anhydrides such as maleic acid anhydride, phthalic acid anhydride, tetrahydrophthalic acid anhydride, pyromellitic acid anhydride, and trimellitic acid anhydride.

The amino group may be either an unsubstituted amino group or a substituted amino group, and for example, an amino group represented by General Formula (B) is preferable.

-N(R^{B1})₂ (B)

In the formula, R^{B1} represents a hydrogen atom or an alkyl group. However, at least one of R^{B1} is a hydrogen atom.

The alkyl group may be any of linear, branched, or cyclic.

The number of carbon atoms in the alkyl group is, for example, 1 to 10, preferably 1 to 6, and more preferably 1 to 3. Moreover, the alkyl group may further have a substituent (for example, a group exemplified in the substituent group Y).

The compound X1 is preferably a compound having one or more functional groups selected from the group consisting of an alkenyl group, an acrylate group, a methacrylate group, and a silyl group, and more preferably a compound having two or more alkenyl groups bonded to a silicon atom, which is a linear or branched organopolysiloxane, from the viewpoint of more excellent thermally conductive properties of the obtained thermally conductive material. A weight average molecular weight of the linear or branched organopolysiloxane is not particularly limited, but is, for example, 1,000 to 50,000.

As a compound which is a linear or branched organopolysiloxane and has two or more alkenyl groups bonded to a silicon atom, an organopolysiloxane including one or more selected from the group consisting of D unit, T unit, and Q unit as a basic constituent unit is preferable, an organopolysiloxane including one or more of the D unit and the T unit as a basic constituent unit is more preferable, and an organopolysiloxane represented by Formula (C) is even more preferable.

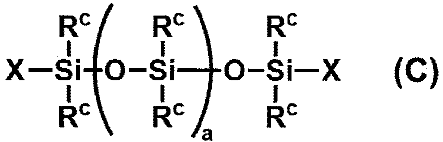

In the formula, R^{C} each independently represents an unsubstituted or substituted hydrocarbon group containing no aliphatic unsaturated bond. X represents an alkenyl group. a represents a number from 0 to 2,000.

Examples of the hydrocarbon group represented by R^{C} include an alkyl group, an aryl group, and an aralkyl group.

The alkyl group may be any of linear, branched, or cyclic.

The number of carbon atoms of the alkyl group is, for example, 1 to 12, and preferably 1 to 6.

Examples of the alkyl group include a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group, a dodecyl group, a cyclopentyl group, a cyclohexyl group, a cycloheptyl group, and the like.

The number of carbon atoms of the aryl group is, for example, 6 to 12. The aryl group may be monocyclic or polycyclic.

Examples of the aryl group include a phenyl group, a tolyl group, a xylyl group, a naphthyl group, a biphenylyl group, and the like.

In the aralkyl group, one of the hydrogen atoms of the alkyl group is substituted with an aryl group, and the alkyl group moiety may be any of linear, branched, or cyclic.

The preferred aspect of the alkyl group moiety in the aralkyl group is the same as that of the alkyl group, and the preferred aspect of the aryl group moiety is the same as that of the aryl group.

Examples of the aralkyl group include a benzyl group, a phenylethyl group, a phenylpropyl group, a methylbenzyl group, and the like.

The hydrocarbon group represented by R^{C} may further have a substituent. Examples of the substituent include the groups exemplified in the aforementioned substituent group Y, and among them, a halogen atom or a cyano group is preferable. Examples of the hydrocarbon group having a substituent include a chloromethyl group, a 2-bromoethyl group, a 3-chloropropyl group, a 3,3,3-trifluoropropyl group, a chlorophenyl group, a fluorophenyl group, a cyanoethyl group, and 3,3,4,4,5,5,6,6,6-nonafluorohexyl group, and the like.

The hydrocarbon group represented by R^{C} preferably includes an unsubstituted or substituted alkyl group having one to three carbon atoms such as a methyl group, an ethyl group, a propyl group, a chloromethyl group, a bromoethyl group, a 3,3,3-trifluoropropyl group, and a cyanoethyl group, or an unsubstituted or substituted phenyl group such as a phenyl group, a chlorophenyl group, and a fluorophenyl group.

As the alkenyl group represented by X, an alkenyl group having 2 to 8 carbon atoms such as a vinyl group, an allyl group, a propenyl group, an isopropenyl group, a butenyl group, a hexenyl group, and a cyclohexenyl group is preferable, a vinyl group or an allyl group is more preferable, and a vinyl group is even more preferable.

The compound X1 may contain a plurality of specific functional groups in the molecule. In a case where the compound X1 contains a plurality of specific functional groups in the molecule, those containing at least a functional group selected from the group consisting of an alkenyl group, an acrylate group, a methacrylate group, and a silyl group can be preferably used, from the viewpoint of more excellent thermally conductive properties.

Hereinafter, specific examples of the compound X1 will be illustrated, but the compound X1 is not limited thereto.

As the compound X1 having an alkenyl group as a specific functional group, a commercially available product such as VF-600 produced by Shin-Etsu Chemical Co., Ltd. can be used.

Examples of the compound X1 having a (meth)acrylate group as a specific functional group include dipentaerythritol triacrylate (as commercially available product, KAYARAD D-330; produced by Nippon Kayaku Co., Ltd.), dipentaerythritol tetraacrylate (as commercially available product, KAYARAD D-320; produced by Nippon Kayaku Co., Ltd.), dipentaerythritol penta(meth)acrylate (as commercially available product, KAYARAD D-310; produced by Nippon Kayaku Co., Ltd.), dipentaerythritol hexa(meth)acrylate (as commercially available product, KAYARAD DPHA; produced by Nippon Kayaku Co., Ltd.), NK ester A-DPH-12E; produced by SHIN-NAKAMURA CHEMICAL CO., LTD), and a structure in which these (meth)acryloyl groups are bonded via ethylene glycol and/or propylene glycol residue (for example, SR454 and SR499 commercially available from Sartomer Co., Ltd.).

These oligomer types can also be used.

In addition, as the compound X1 having a (meth)acrylate group as a specific functional group, KAYARAD RP-1040 and DPCA-20 (produced by Nippon Kayaku Co., Ltd.) can also be used.

In addition, as the compound X1 having a (meth)acrylate group as a specific functional group, a trifunctional (meth)acrylate compound such as trimethylolpropane tri(meth)acrylate, trimethylolpropane propyleneoxy-modified tri(meth)acrylate, trimethylolpropane ethyleneoxy-modified tri(meth)acrylate, isocyanuric acid ethyleneoxy-modified tri(meth)acrylate, and pentaerythritol tri(meth)acrylate can also be used. Examples of commercially available product of trifunctional (meth)acrylate compounds include Aronix M-309, M-310, M-321, M-350, M-360, M-313, M-315, M-306, M-305, M-303, M-452, M-450 (produced by TOAGOSEI CO., LTD.), NK ester A9300, A-GLY-9E, A-GLY-20E, A-TMM-3, A-TMM-3L, A-TMM-3LM-N, A-TMPT, TMPT (produced by SHIN-NAKAMURA CHEMICAL CO., LTD.), KAYARAD GPO-303, TMPTA, THE-330, TPA-330, PET-30 (produced by Nippon Kayaku Co., Ltd.), and the like.

Examples of the compound X1 having a silyl group as a specific functional group include tetramethoxysilane, tetraethoxysilane, tetra n-propoxysilane, tetra i-propoxysilane, tetra n-butoxysilane, tetra i-butoxysilane, methyltrimethoxysilane, methyltriethoxysilane, ethyltrimethoxysilane, ethyltriethoxysilane, n-propyltrimethoxysilane, n-propyltriethoxysilane, i-propyltrimethoxysilane, i-propyltriethoxysilane, n-butyltrimethoxysilane, i-butyltrimethoxysilane, γ-chloropropyltrimethoxysilane, γ-chloropropyltriethoxysilane, 3,3,3-trifluoropropyltrimethoxysilane, 3,3,3-trifluoropropyltriethoxysilane, 3 -methacryloyloxypropyltrimethoxysilane, 3-methacryloyloxypropyltriethoxysilane, γ-mercaptopropyltrimethoxysilane, γ-mercaptopropyltriethoxysilane, γ-aminopropyltrimethoxysilane, γ-aminopropyltriethoxysilane, vinyltrimethoxysilane, vinyltriethoxysilane, phenyltrimethoxysilane, phenyltriethoxysilane, dimethyldimethoxysilane, dimethyldiethoxysilane, diethyldimethoxysilane, and the like.

As a commercially available product, for example, KBM-503 sold by Shin-Etsu Chemical Co., Ltd. can be used.

As the compound X1 having an acid anhydride group as a specific functional group, 3-methyl-1,2,3,6-tetrahydrophthalic acid anhydride, maleic acid anhydride, phthalic acid anhydride, pyromellitic acid anhydride, trimellitic acid anhydride, and the like can be used.

Examples of the compound X1 having a cyanate ester group as a specific functional group include monofunctional or difunctional cyanate ester resin such as bisphenol A dicyanate, polyphenol cyanate [oligo (3-methylene-1,5-phenylene cyanate)], 4,4-methylenebis(2,6-dimethylphenylcyanate), 4,4-ethylidendiphenyl dicyanate, hexafluorobisphenol A dicyanate, 2,2-bis(4-cyanate) phenylpropane, 1,1-bis(4-cyanate phenylmethane), bis(4-cyanate-3,5-dimethylphenyl)methane, 1,3-bis[4-cyanatephenyl-1-(methylethylidene)]benzene, bis(4-cyanatephenyl)thioether and bis(4-cyanatephenyl)ether, novolac-type cyanate ester resins derived from phenol novolac, cresol novolac, or the like, and prepolymers obtained by triazineing a part of these cyanate ester resins.

As commercially available products, for example, L-10, XU366, XU378, XU371 sold by Huntsman Japan Corporation, CYTESTER TA, CYTESTER NCN sold by MITSUBISHI GAS CHEMICAL COMPANY, INC, and the like can be used.

Examples of the compound X1 having an amino group as a specific functional group include 4,4-diaminodiphenyl ether, 4,4-diaminodiphenylmethane, 3,3-diaminodiphenylmethane, 3,3-dichlorobenzidine, 4,4-diaminodiphenylsulfide, 3,3-diaminodiphenylsulfone, 1,5-diaminonaphthalene, m-phenylenediamine, p-phenylenediamine, 3,3-dimethyl-4,4-biphenyldiamine, benzidine, 3,3-dimethylbenzidine, 3,3 -dimethoxybenzidine, 4,4-diaminodiphenylsulfone, 4,4-diaminodiphenylsulfide, 4,4-diaminodiphenyl propane, and the like.

Examples of the compound X1 having a thiol group as a specific functional group include 1,4-bis(3-mercaptobutyryloxy)butane, di(1-mercaptoethyl) 3-mercaptophthalate, di(2-mercaptopropyl)phthalate, di(3-mercaptobutyl)phthalate, ethylene glycol bis(3-mercaptobutyrate), propylene glycol bis(3-mercaptobutyrate), diethylene glycol bis(3-mercaptobutyrate), butanediol bis(3-mercaptobutyrate), octanediol bis(3-mercaptobutyrate), trimethylolethane tris(3-mercaptobutyrate), trimethylolpropane tris(3-mercaptobutyrate), pentaerythritol tetrakis(3-mercaptobutyrate), dipentaerythritol hexakis(3-mercaptobutyrate), ethylene glycol bis(2-mercaptopropionate), propylene glycol bis(2-mercaptopropionate), diethylene glycol bis(2-mercaptopropionate), butanediol bis(2-mercaptopropionate), octanediol bis(2-mercaptopropionate), trimethylolpropane tris(2-mercaptopropionate), pentaerythritol tetrakis(2-mercaptopropionate), dipentaerythritol hexakis(2-mercaptopropionate), ethylene glycol bis(4-mercaptovalerate), diethylene glycol bis(4-mercaptovalerate), butanediol bis(4-mercaptovalerate), octanediol bis(4-mercaptovalerate), trimethylolpropane tris(4-mercaptovalerate), pentaerythritol tetrakis(4-mercaptovalerate), dipentaerythritol hexakis(4-mercaptovalerate), ethylene glycol bis(3-mercaptovalerate), propylene glycol bis(3-mercaptovalerate), diethylene glycol bis(3-mercaptovalerate), butanediol bis(3-mercaptovalerate), octanediol bis(3-mercaptovalerate), trimethylolpropane tris(3-mercaptovalerate), pentaerythritol tetrakis(3-mercaptovalerate), dipentaerythritol hexakis(3-mercaptovalerate), hydrogenated bisphenol A bis(3-mercaptobutyrate), bisphenol A dihydroxyethyl ether-3-mercaptobutyrate, 4,4'-(9-fluorenylidene)bis(2-phenoxyethyl (3-mercaptobutyrate)), ethylene glycol bis(3-mercapto-3-phenylpropionate), propylene glycol bis(3-mercapto-3-phenylpropionate), diethylene glycol bis(3-mercapto-3-phenylpropionate), butanediol bis(3-mercapto-3-phenylpropionate), octanediol bis(3-mercapto-3-phenylpropionate), trimethylolpropane tris(3 -mercapto-3 -phenylpropionate), tris-2-(3 -mercapto-3 -phenylpropionate)ethyl isocyanurate, pentaerythritol tetrakis(3 -mercapto-3 -phenylpropionate), dipentaerythritol hexakis(3 -mercapto-3 -phenylpropionate), 1,3,5-tris[2-(3-mercaptobutyryloxyethyl)]-1,3,5-triazine-2,4,6 (1H, 3H, 5H)-trione, and the like.

In addition, as the compound X1 having a thiol group as a specific functional group, 1,4-bis(3-mercaptobutyryloxy) butane (as a commercially available product, "Karensu MT BD1" produced by SHOWA DENKO K.K.), pentaerythritol tetrakis(3-mercaptobutyrate) (as a commercially available product, "Karensu MT PE1" produced by SHOWA DENKO K.K.), 1,3,5-tris [2-(3-mercaptobutyryloxyethyl)]-1,3,5-triazine-2,4,6 (1H, 3H, 5H)-trione (as a commercially available product, "Karensu MT NR1" produced by SHOWA DENKO K.K.), trimethylolethane tris(3-mercaptobutyrate) (as a commercially available product, "TEMB" produced by SHOWA DENKO K.K.), trimethylolethanepropane tris(3-mercaptobutyrate) (as a commercially available product, "TPMB" produced by SHOWA DENKO K.K.), and the like can also be used.

In addition, as the compound X1 having a thiol group as a specific functional group, di(2-mercaptoisobutyl)phthalate, ethylene glycol bis(2-mercaptoisobutyrate), propylene glycol bis(2-mercaptoisobutyrate), diethylene glycol bis (2-mercaptoisobutyrate), butanediol bis(2-mercaptoisobutyrate), octanediol bis(2-mercaptoisobutyrate), trimethylolethane tris (2-mercaptoisobutyrate), trimethylolethanepropane tris(2-mercaptoisobutyrate), pentaerythritol tetrakis(2-mercaptoisobutyrate), dipentaerythritol hexakis(2-mercaptoisobutyrate), diphthalate (3-mercapto-3-methylbutyl), ethylene glycol bis(3-mercapto-3-methylbutyrate), propylene glycol bis(3-mercapto-3-methylbutyrate), diethylene glycol bis(3-mercapto-3-methylbutyrate), butanediol bis(3-mercapto) -3-methylbutyrate), octanediol bis(3-mercapto-3-methylbutyrate), trimethylolethane tris(3 -mercapto-3 -methylbutyrate), trimethylolpropane tris(3-mercapto-3-methylbutyrate), pentaerythritol tetrakis(3 -mercapto-3 -methylbutyrate), dipentaerythritol hexakis(3-mercapto-3-methylbutyrate), and the like can also be used.

As the compound X1 having a carboxylic acid group as a specific functional group, acrylic acid, methacrylic acid, ethacrylic acid, fumaric acid, maleic acid, maleic acid monoalkyl esters (maleic acid monomethyl ester, maleic acid monoethyl ester, and the like), and the like can also be used.

In a case where the specific functional group is an acid anhydride group, a cyanate ester group, an amino group, a thiol group, or a carboxylic acid group, the compound X1 containing the specific functional group can react with the epoxy compound. In a case where the specific functional group is an acid anhydride group, a cyanate ester group, an amino group, a thiol group, or a carboxylic acid group, a content of the specific functional group of the compound X1 is preferably 0.01 to 100 mmol/g, and more preferably 0.1 to 50 mmol/g.

The content of the specific functional group is intended to be the number of specific functional groups contained in 1 g of the compound X1.

In addition, in a case where the specific functional group is an acid anhydride group, a cyanate ester group, an amino group, a thiol group, or a carboxylic acid group, a ratio of the content of the epoxy compound in the composition to a total content of the compound X1 and an optionally contained curing agent (for example, phenolic compound described later) (an equivalent ratio of an epoxy group of the epoxy compound and a functional group capable of reacting with the epoxy group in the compound X1 and a functional group capable of reacting with the epoxy group in the optionally contained curing agent) (number of epoxy groups/number of functional groups capable of reacting with the epoxy groups) is as described above.

In a case where the specific functional group is an alkenyl group, an acrylate group, or a methacrylate group, the compound X1 containing the specific functional group can cause a polymerization reaction.

In a case where the specific functional group is a silyl group (particularly, a hydrolyzable silyl group), the compound X1 containing the specific functional group can cause a self-condensation reaction.

### <Compound X2>

The compound X2 is a compound having a polyamic acid structure.

A compound having a polyamic acid structure is obtained by performing polymerization reaction on acid dianhydride and diamine, and has a polymer structure (polyamic acid structure) containing a repeating unit having a -CO-NH- bond and a -COOH group.

Examples of the acid dianhydride include aromatic tetracarboxylic acid dianhydride such as pyromellitic acid dianhydride, 3,3,4,4-benzophenone tetracarboxylic acid dianhydride, 3,3,4,4-biphenyltetracarboxylic acid dianhydride, 2,3,3,4-biphenyltetracarboxylic acid dianhydride, 2,3,6,7-naphthalenetetracarboxylic acid dianhydride, 1,2,5,6-naphthalenetetracarboxylic acid dianhydride, and 1,4,5,8-naphthalenetetracarboxylic acid dianhydride. In addition, two or more kinds thereof may also be used.

Examples of the diamines include aromatic diamine such as 4,4-diaminodiphenyl ether, 4,4-diaminodiphenylmethane, 3,3-diaminodiphenylmethane, 3,3-dichlorobenzidine, 4,4-diaminodiphenylsulfide, 3,3-diaminodiphenylsulfone, 1,5-diaminonaphthalene, m-phenylenediamine, p-phenylenediamine, 3,3-dimethyl-4,4-biphenyldiamine, benzidine, 3,3 -dimethylbenzidine, 3,3 -dimethoxybenzidine, 4,4-diaminodiphenylsulfone, 4,4-diaminodiphenylsulfide, and 4,4-diaminodiphenylpropane. In addition, two or more kinds thereof may also be used.

The weight average molecular weight of the compound X2 is not particularly limited, but is, for example, 1,000 to 300,000, and preferably 3,000 to 100,000.

The compound X is a compound having one or more functional groups selected from the group consisting of an alkenyl group, an acrylate group, a methacrylate group, and a silyl group, from the viewpoint that the obtained thermally conductive material has more excellent thermally conductive properties, or is preferably a compound having a polyamic acid structure, and more preferably a compound having two or more alkenyl groups bonded to a silicon atom, which is a linear or branched organopolysiloxane.

One kind of the compound X may be used singly, or two or more kinds thereof may be used.

In the composition according to the embodiment of the present invention, a content of the compound X is 10% by mass or more, and preferably 15% by mass or more, with respect to the total solid content of the composition. In addition, an upper limit value is, for example, 50% by mass or less, preferably 40% by mass or less, and more preferably 35% by mass or less.

### [Curing agent]

The composition according to the embodiment of the present invention also preferably contains a curing agent capable of reacting with the epoxy compound.

As the curing agent, a phenolic compound and an acid anhydride are preferable.

Examples of the phenolic compound include phenolic compounds described later.

Examples of the acid anhydride include 3-methyl-1,2,3,6-tetrahydrophthalic acid anhydride, 4-methyl-1,2,3,6-tetrahydrophthalic acid anhydride, 3-methyl-hexahydrophthalic acid anhydride, 4-methyl-hexahydrophthalic acid anhydride, and the like.

As the curing agent, a phenolic compound is more preferable, from the viewpoint of more excellent thermally conductive properties of the thermally conductive material.

The acid anhydride also corresponds to the compound X1. That is, a compound having one or more acid anhydride groups of the compound X1 may have a function as a curing agent. In a case where the composition according to the embodiment of the present invention contains a compound having one or more acid anhydride groups as the compound X1, the composition preferably contains a phenolic compound as a curing agent.

A lower limit value of the content of the functional group capable of reacting with the epoxy compound of the curing agent (hereinafter, also referred to as "content of functional group") is preferably 3.0 mmol/g or more, and more preferably 12.0 mmol/g or more. An upper limit value thereof is preferably 25.0 mmol/g or less, and more preferably 20.0 mmol/g or less.

The content of the functional group is intended to be the number of functional groups contained in 1 g of the curing agent.

A molecular weight of the curing agent is not particularly limited, but is preferably 600 or less. The lower limit value is not particularly limited, but 110 or greater is preferable.

One kind of the curing agent may be used singly, or two or more kinds thereof may be used.

In a case where the composition according to the embodiment of the present invention contains a curing agent, a content of the curing agent is preferably 1.0% by mass or greater with respect to the total solid content of the composition. An upper limit value is not particularly limited, but is preferably 25.0% by mass or less.

### <Phenolic compound>

The phenolic compound is a compound having one or more (preferably two or more and more preferably three or more) phenolic hydroxyl groups.

From the viewpoint of more excellent thermally conductive properties, the phenolic compound is preferably one or more selected from the group consisting of a compound represented by General Formula (P1) and a compound represented by General Formula (P2).

### <Compound represented by General Formula (P1)>

General Formula (P1) will be shown below.

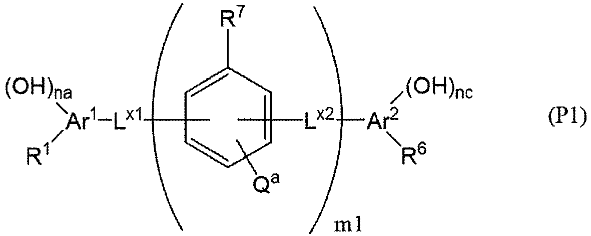

In General Formula (PI), m1 represents an integer of 0 or greater.

m1 is preferably 0 to 10, more preferably 0 to 3, even more preferably 0 or 1, and particularly preferably 1.

In General Formula (PI), na and nc each independently represent an integer of 1 or greater.

na and nc are each independently preferably 1 to 4.

In General Formula (PI), R¹ and R⁶ each independently represent a hydrogen atom, a halogen atom, a carboxylic acid group, a boronic acid group, an aldehyde group, an alkyl group, an alkoxy group, or an alkoxycarbonyl group.

The alkyl group may be linear or branched. The number of carbon atoms in the alkyl group is preferably 1 to 10. The alkyl group may or may not have a substituent.

An alkyl group moiety in the alkoxy group and an alkyl group moiety in the alkoxycarbonyl group are the same as the aforementioned alkyl group.

R¹ and R⁶ are each independently preferably a hydrogen atom or a halogen atom, more preferably a hydrogen atom or a chlorine atom, and even more preferably a hydrogen atom.

In General Formula (PI), R⁷ represents a hydrogen atom or a hydroxyl group.

In a case where there are a plurality of R⁷'s, the plurality of R⁷'s may be the same as or different from each other.

In a case where there is the plurality of R⁷'s, at least one R⁷ among the plurality of R⁷'s preferably represents a hydroxyl group.

In General Formula (PI), L^{x1} represents a single bond, -C(R²) (R³)-, -C(R⁸)(R⁹)-C(R¹⁰)(R¹¹)-, or -CO-, and preferably represents -C(R²)(R³)-, -C(R⁸)(R⁹)-C(R¹⁰)(R¹¹)-, or-CO-.

L^{x2} represents a single bond, -C(R⁴)(R⁵)-, or -CO-, and preferably represents -C(R⁴)(R⁵)- or -CO-.

R² to R⁵ and R⁸ to R¹¹ each independently represent a hydrogen atom or a substituent.

The substituents are each independently preferably a hydroxyl group, a phenyl group, a halogen atom, a carboxylic acid group, a boronic acid group, an aldehyde group, an alkyl group, an alkoxy group, or an alkoxycarbonyl group, and more preferably a hydroxyl group, a halogen atom, a carboxylic acid group, a boronic acid group, an aldehyde group, an alkyl group, an alkoxy group, or an alkoxycarbonyl group.

The alkyl group may be linear or branched. The number of carbon atoms in the alkyl group is preferably 1 to 10. The alkyl group may or may not have a substituent.

An alkyl group moiety in the alkoxy group and an alkyl group moiety in the alkoxycarbonyl group are the same as the aforementioned alkyl group.

The phenyl group may or may not have a substituent, and in a case where the phenyl group has a substituent, the phenyl group more preferably has one to three hydroxyl groups.

R² to R⁵ are each independently preferably a hydrogen atom or a hydroxyl group, and more preferably a hydrogen atom.

R⁸ to R¹¹ are each independently preferably a hydrogen atom or a phenyl group. The phenyl group more preferably has 1 to 3 hydroxyl groups.

L^{x1} is preferably -CH₂-, -CH(OH)-, -CO-, -CH(Ph)-, -CCH₃(CH₃)-, or -CH(Ph)-CH(Ph)-, and more preferably -CH₂-, -CH(OH)-, -CO-, or -CH (Ph)-. L^{x2} is preferably -CH₂-, -CH(OH)-, -CO-, or -CH(Ph)-.

The Ph represents a phenyl group which may have a substituent.

In General Formula (PI), in a case where there is a plurality of R⁴'s, the plurality of R⁴'s may be the same as or different from each other. In a case where there are a plurality of R⁵'s, the plurality of R⁵'s may be the same as or different from each other.

In General Formula (PI), Ar¹ and Ar² each independently represent a benzene ring group or a naphthalene ring group.

Ar¹ and Ar² are each independently preferably a benzene ring group.

In General Formula (PI), Q^{a} represents a hydrogen atom, an alkyl group, a phenyl group, a halogen atom, a carboxylic acid group, a boronic acid group, an aldehyde group, an alkoxy group, or an alkoxycarbonyl group.

The alkyl group may be linear or branched. The number of carbon atoms in the alkyl group is preferably 1 to 10. The alkyl group may or may not have a substituent.

An alkyl group moiety in the alkoxy group and an alkyl group moiety in the alkoxycarbonyl group are the same as the aforementioned alkyl group.

The phenyl group may or may not have a substituent.

Q^{a} is preferably bonded to a para position with respect to a hydroxyl group that a benzene ring group, to which Q^{a} is bonded, may have.

Q^{a} is preferably a hydrogen atom or an alkyl group. The alkyl group is preferably a methyl group.

In General Formula (PI), in a case where there are a plurality of R⁷'s, L^{x2}'s and/or Q^{a}'s, the plurality of R⁷'s, L^{x2}'s, and/or Q^{a}'s may be the same as or different from each other.

In addition, examples of the phenolic compound preferably include benzene polyol such as benzenetriol, a biphenyl aralkyl-type phenolic resin, a phenol novolac resin, a cresol novolac resin, an aromatic hydrocarbon formaldehyde resin-modified phenolic resin, a dicyclopentadiene phenol addition-type resin, a phenol aralkyl resin, a polyhydric phenol novolac resin synthesized from a polyhydric hydroxy compound and formaldehyde, a naphthol aralkyl resin, a trimethylolmethane resin, a tetraphenylolethane resin, a naphthol novolac resin, a naphthol phenol co-condensed novolac resin, a naphthol cresol co-condensed novolac resin, a biphenyl-modified phenolic resin, a biphenyl-modified naphthol resin, an aminotriazine-modified phenolic resin, an alkoxy group-containing aromatic ring-modified novolac resin, or the like.

A lower limit value of the hydroxyl group content of the phenolic compound is preferably 3.0 mmol/g or greater and more preferably 12.0 mmol/g or greater. An upper limit value thereof is preferably 25.0 mmol/g or less, and more preferably 20.0 mmol/g or less.

Moreover, the hydroxyl group content means a number of hydroxyl groups (preferably, phenolic hydroxyl groups) contained in 1 g of the phenolic compound.

In addition, the phenolic compound may have an active hydrogen-containing group (carboxylic acid group and the like) capable of a polymerization reaction with an epoxy compound, in addition to the hydroxyl group. A lower limit value of the content (total content of hydrogen atoms in a hydroxyl group, a carboxylic acid group, and the like) of an active hydrogen in the phenolic compound is preferably 3.0 mmol/g or greater and more preferably 7.0 mmol/g or greater. An upper limit value thereof is preferably 25.0 mmol/g or less, and more preferably 20.0 mmol/g or less.

The content of the active hydrogen means a number of active hydrogen atoms contained in 1 g of the phenolic compound.

An upper limit value of the molecular weight of the phenolic compound is preferably 600 or less, more preferably 500 or less, and even more preferably 400 or less. A lower limit value is preferably 110 or greater, more preferably 250 or greater, and even more preferably 300 or greater.

One kind of the phenolic compounds may be used singly, or two or more kinds thereof may be used.

In a case where the composition according to the embodiment of the present invention contains the phenolic compound, a content of the phenolic compound is preferably 1.0% by mass or greater, more preferably 3.0% to 25.0% by mass, and even more preferably 5.0% to 20.0% by mass, with respect to the total solid content of the composition.

A ratio of the content of the epoxy compound to the content of the phenolic compound in the composition is as described above.

### [Surface modifier]

The composition according to the embodiment of the present invention may further contain a surface modifier from the viewpoint of more excellent thermally conductive properties of the thermally conductive material.

The surface modifier is a component that surface-modifies the aforementioned inorganic substance.

In the present specification, "surface modification" means a state where an organic substance is adsorbed onto at least a part of a surface of the inorganic substance. A form of the adsorption is not particularly limited, and may be in a bonded state. That is, the surface modification also includes a state in which an organic group obtained by desorbing a part of the organic substance is bonded to the surface of the inorganic substance. The bond may be any one of a covalent bond, a coordinate bond, an ionic bond, a hydrogen bond, a van der Waals bond, or a metallic bond. The surface modification may be performed so that a monolayer is formed on at least a part of the surface. The monolayer is a single-layer film formed by chemical adsorption of organic molecules, and is known as a self-assembled monolayer (SAM). Moreover, in the present specification, the surface modification may be performed only on a part of the surface of the inorganic substance, or may be performed on the entire surface thereof. In the present specification, a "surface-modified inorganic substance" means an inorganic substance of which the surface modifier is surface-modified, that is, a substance in which an organic substance is adsorbed onto a surface of the inorganic substance.

That is, in the composition according to the embodiment of the present invention, the inorganic substance may form a surface-modified inorganic substance (preferably, a surface-modified inorganic nitride and/or a surface-modified inorganic oxide) in cooperation with the surface modifier.

As the surface modifier, a known surface modifier in the related art such as a carboxylic acid such as long-chain alkyl fatty acid, organic phosphonic acid, organic phosphoric acid ester, and organic silane molecules (silane coupling agent) can be used. In addition, for example, the surface modifier described in JP2009-502529A, JP2001-192500A, and JP4694929B may be used.

In addition, the composition (preferably, in a case where the inorganic substance contains an inorganic nitride (boron nitride and/or aluminum nitride, and the like)) preferably contains a compound having a condensed ring skeleton or a triazine skeleton as a surface modifier.

### <Surface modifier A>

As the surface modifier, for example, the surface modifier A described below is preferable. The surface modifier A is a surface modifier having a condensed ring skeleton.

The surface modifier A satisfies the following conditions 1 and 2.
- Condition 1: The surface modifier has a functional group selected from a group of functional groups P shown below (hereinafter, also referred to as "specific functional group A").

### (Group of functional groups P)

A functional group selected from the group consisting of boronic acid group (-B(OH)₂), aldehyde group (-CHO), isocyanate group (-N = C = O), isothiocyanate group (-N = C = S), cyanate group (-O-CN), acyl azide group, succinimide group, sulfonyl chloride group (-SO₂Cl), carboxylic acid chloride group (-COCl), onium group, carbonate group (-O-CO-O-), aryl halide group, carbodiimide group (-N) = C = N-), acid anhydride group (-CO-O-CO-, or monovalent acid anhydride group such as maleic acid anhydride, phthalic acid anhydride, pyromellitic acid anhydride, and trimellitic acid anhydride), carboxylic acid group (-COOH), phosphonic acid group (-PO(OH)2), phosphinic acid group (-HPO(OH)), phosphoric acid group (-OP(= O) (OH)₂), phosphoric acid ester group (-OP(= O)(OR^{B})₂), sulfonic acid group (-SO₃H), hydrogenated alkyl group, nitrile group (-CN), nitro group (-NO₂), ester group (-CO-O- or -O-CO-), carbonyl group (-CO-), imide ester group (-C(= NR_{C})-O- or -O-C(= NRc)-), alkoxysilyl group, acrylic group (-OCOCH₂ = CH2), methacryl group (-OCOCH (CH₃) = CH2), oxetanyl group, vinyl group (-CH = CH2), alkynyl group (group in which one hydrogen atom is removed from alkyne. For example, ethynyl group, prop-2-in-1-yl group and the like are included.), maleimide group, thiol group (-SH), hydroxyl group (-OH), halogen atom (F atom, Cl atom, Br atom, and I atom), and an amino group.

The acyl azide group is intended to be a group represented by the following structure. ^{∗} in the formula represents a bonding position. A counter anion (Z⁻) of the acyl azide group is not particularly limited, and examples thereof include halogen ions.

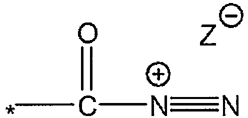

The succinimide group, the oxetanyl group, and the maleimide group each represent a group formed by removing one hydrogen atom at an optional position from the compound represented by the following formula.

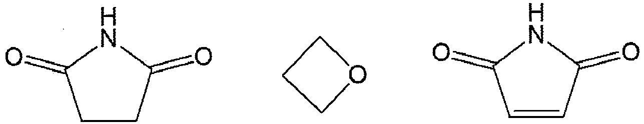

In addition, the onium group means a group having an onium salt structure. An onium salt is a compound produced by a compound having an electron pair that is not involved in a chemical bond having a coordinate bond with another cation-type compound by the electron pair. Usually, onium salts contain cations and anions.

The onium salt structure is not particularly limited, and examples thereof include an ammonium salt structure, a pyridinium salt structure, an imidazolium salt structure, a pyrrolidinium salt structure, a piperidinium salt structure, a triethylenediamine salt structure, a phosphonium salt structure, a sulfonium salt structure, a thiopyrylium salt structure, and the like. The kind of anion serving as a counter is not particularly limited, and a known anion is used. The valence of the anion is also not particularly limited, and examples thereof include 1 to 3 valences, and preferably 1 to 2 valences.

As the onium group, a group having an ammonium salt structure represented by General Formula (Al) is preferable.

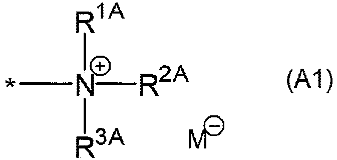

In General Formula (Al), R^{1A} to R^{3A} each independently represent a hydrogen atom or an alkyl group (including all of a linear alkyl group, a branched alkyl group, and a cyclic alkyl group). The number of carbon atoms in the alkyl group is, for example, 1 to 10, preferably 1 to 6, and more preferably 1 to 3. M⁻ represents an anion. ^{∗} represents a bonding position. Moreover, the alkyl group may further have a substituent (for example, the substituent group Y).

The aryl halide group is not particularly limited as long as it is a group in which one or more halogen atoms are substituted in the aromatic ring group. The aromatic ring group may have either a monocyclic structure or a polycyclic structure, but a phenyl group is preferable. In addition, examples of the halogen atom include a chlorine atom, a fluorine atom, a bromine atom, and an iodine atom, and the fluorine atom is preferable. The aryl halide group may further have a substituent (for example, the substituent group Y).

Specific examples of the aryl halide group include a fluorophenyl group, a perfluorophenyl group, a chlorophenyl group, a bromophenyl group, an iodophenyl group, and the like.

The phosphoric acid ester group is not particularly limited as long as it is a group represented by -OP(= O)(OR^{B})₂. Examples of the R^{B} include a hydrogen atom or a monovalent organic group. However, any one or more of R^{B}s represent monovalent organic groups. Examples of the monovalent organic group include an alkyl group (including all of linear, branched, and cyclic groups) and an aryl group. The number of carbon atoms in the alkyl group is, for example, 1 to 10, preferably 1 to 6, and more preferably 1 to 3. Moreover, the alkyl group may further have a substituent (for example, the substituent group Y). In addition, the aryl group is not particularly limited, and examples thereof include a phenyl group, a pyrenyl group, and the like.

The hydrogenated alkyl group is not particularly limited, and examples thereof include a group in which one or more halogen atoms are substituted in an alkyl group having 1 to 10 carbon atoms. The number of carbon atoms in the alkyl group (including all of linear, branched, and cyclic) is preferably 1 to 6, and more preferably 1 to 3. Examples of the halogen atom include a fluorine atom, a chlorine atom, a bromine atom, and an iodine atom, and a fluorine atom, a chlorine atom, or a bromine atom is preferable. The hydrogenated alkyl group may further have a substituent (for example, the substituent group Y).

The imide ester group is not particularly limited as long as it is a group represented by -C(= NR^{C})-O- or -O-C(= NR^{C})-. Examples of the R^{C} include a hydrogen atom and an alkyl group (including all of linear, branched, and cyclic). The number of carbon atoms in the alkyl group is, for example, 1 to 10, preferably 1 to 6, and more preferably 1 to 3. Moreover, the alkyl group may further have a substituent (for example, the substituent group Y).

The imide ester group may have an onium salt structure in which an electron pair that is not involved in the chemical bond of imine nitrogen has a coordinate bond with another cation (for example, a hydrogen ion).

The alkoxysilyl group is not particularly limited, and examples thereof include a group represented by General Formula (A2).

General Formula (A2): ^{∗}-Si(OR^{D})₃

In General Formula (A2), R^{D}'s each independently represent an alkyl group (including all of a linear alkyl group, a branched alkyl group, and a cyclic alkyl group). ^{∗} represents a bonding position.

The alkyl group represented by R^{D} is, for example, an alkyl group having 1 to 10 carbon atoms, preferably having 1 to 6 carbon atoms, and more preferably having 1 to 3 carbon atoms.

Specific examples thereof include a trimethoxysilyl group and a triethoxysilyl group.

Moreover, the alkyl group may further have a substituent (for example, the substituent group Y).

The amino group is not particularly limited, and may be any of primary, secondary, and tertiary amino group. Specific examples thereof include -N(R^{E})₂ (R^{E}'s are each independently hydrogen atoms or alkyl groups (including all of a linear alkyl group, a branched alkyl group, and a cyclic alkyl group)). The number of carbon atoms in the alkyl group is, for example, 1 to 10, preferably 1 to 6, and more preferably 1 to 3. Moreover, the alkyl group may further have a substituent (for example, the substituent group Y).

The number of the specific functional groups A in the surface modifier A is not particularly limited as long as the number of the specific functional groups A is 1 or more. In addition, an upper limit thereof is not particularly limited, but is preferably 15 or less. Among them, the upper limit thereof is preferably 1 to 8, more preferably 1 to 3, and even more preferably 1 or 2, from the viewpoint of more excellent dispersibility of the surface-modified inorganic nitride.
- Condition 2: The functional group has a condensed ring structure containing two or more rings selected from the group consisting of an aromatic hydrocarbon ring and an aromatic heterocyclic ring.

The aromatic hydrocarbon ring is not particularly limited, and examples thereof include a monocyclic aromatic hydrocarbon ring having 5 or more membered rings. An upper limit of the number of ring members is not particularly limited, but is 10 or less in many cases. As the aromatic hydrocarbon ring, a 5-membered or 6-membered monocyclic aromatic hydrocarbon ring is preferable.

Examples of the aromatic hydrocarbon ring include a cyclopentadienyl ring and a benzene ring.

The aromatic heterocyclic ring is not particularly limited, and examples thereof include a monocyclic aromatic hydrocarbon ring having 5 or more membered rings. An upper limit of the number of ring members is not particularly limited, but is 10 or less in many cases. As the aromatic heterocyclic ring, for example, a 5-membered or 6-membered monocyclic aromatic heterocyclic ring is preferable.

Examples of the aromatic heterocyclic ring include a thiophene ring, a thiazole ring, an imidazole ring, a pyridine ring, a pyridazine ring, a pyrimidine ring, a pyrazine ring, and a triazine ring.

The condensed structure is not particularly limited as long as it is a condensed ring structure containing two or more rings selected from the group consisting of an aromatic hydrocarbon ring and an aromatic heterocyclic ring, but among them, a condensed ring structure containing two or more aromatic hydrocarbon rings is preferable, a condensed ring structure containing two or more benzene rings is more preferable, and a condensed ring structure containing three or more benzene rings is even more preferable, from the viewpoint of more excellent effects of the present invention. An upper limit of the number of aromatic hydrocarbon rings and aromatic heterocyclic rings contained in the condensed structure is not particularly limited, but is, for example, 10 or less in many cases.

As a specific example of the condensed ring structure containing two or more aromatic hydrocarbon rings, a condensed structure formed of condensed rings selected from the group consisting of biphenylene, indacene, acenaphthylene, fluorene, phenalene, phenanthrene, anthracene, fluoranthene, acephenanthrylene, aceanthrylene, pyrene, chrysene, tetracene, pleiadene, picene, perylene, pentaphene, pentacene, tetraphenylene, hexaphene, and triphenylene is preferable, and from the viewpoint of more excellent effect of the present invention, among them, a condensed structure formed of a condensed ring containing two or more benzene rings is more preferable, a condensed structure formed of a condensed ring containing three or more benzene rings is even more preferable, and a condensed structure formed of pyrene and perylene is particularly preferable.

The surface modifier A is preferably a compound represented by General Formula (V1), and more preferably a compound represented by General Formula (V2), from the viewpoint that the dispersibility is further improved.

Hereinafter, the compound represented by General Formula (V1) and the compound represented by General Formula (V2) will be described respectively.

### (Compound represented by General Formula (VI))

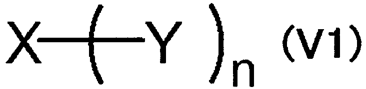

In General Formula (V1), X represents an n-valent organic group having a condensed ring structure containing two or more rings selected from the group consisting of an aromatic hydrocarbon ring and an aromatic heterocyclic ring.

The X represents an n-valent organic group (n is an integer of 1 or more). n is not particularly limited as long as it is an integer of 1 or more. In addition, an upper limit thereof is not particularly limited, but is preferably an integer of 15 or less. Among them, the upper limit thereof is preferably 1 to 8, more preferably 1 to 3, and even more preferably 1 or 2, from the viewpoint of more excellent dispersibility of the surface-modified inorganic nitride.

Examples of the condensed ring structure containing two or more rings selected from the group consisting of an aromatic hydrocarbon ring and an aromatic heterocyclic ring in X include the aforementioned structure, and the preferred aspect is also the same.

The n-valent organic group represented by X is not particularly limited as long as it has a condensed ring structure containing two or more rings selected from the group consisting of aromatic hydrocarbon rings and aromatic heterocyclic rings, and from the viewpoint of more excellent effect of the present invention, a group formed by extracting n hydrogen atoms from a condensed ring containing two or more rings selected from the group consisting of an aromatic hydrocarbon ring and an aromatic heterocyclic ring is preferable.

The condensed structure may further have a substituent (for example, a substituent group Y) in addition to the specific functional group A.

The Y represents a monovalent group represented by General Formula (B1), a monovalent group represented by General Formula (B2), or a monovalent group represented by General Formula (B4), or in a case where n represents an integer of 2 or more, the Y represents a divalent group represented by General Formula (B3) in which a plurality of Y's are bonded.

In other words, in a case where n is 1, the Y represents a monovalent group represented by General Formula (B1), a monovalent group represented by General Formula (B2), or a monovalent group represented by General Formula (B4).

In a case where n represents an integer of 2 or more, the Y represents a monovalent group represented by General Formula (B1), a monovalent group represented by General Formula (B2), or a monovalent group represented by General Formula (B4), or represents a divalent group represented by General Formula (B3) in which a plurality of Y's are bonded. In a case where n is 2 or more, the plurality of Y's may be the same or different.

In a case where Y represents a divalent group represented by General Formula (B3), the compound represented by General Formula (V1) is represented by General Formula (V3).

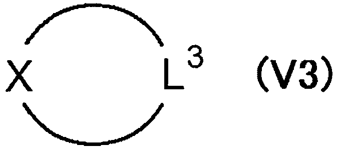

In General Formula (V3), X is synonymous with X in General Formula (V1) described above. In addition, L³ is synonymous with L³ in General Formula (B3) described later.

General Formula (B1): ^{∗1}-L¹-P¹

In General Formula (B1), L¹ represents a single bond or a divalent linking group.

The divalent linking group is not particularly limited, and examples thereof include -O-, -S-, -NR^{F}- (R^{F} represents a hydrogen atom or an alkyl group), a divalent hydrocarbon group (for example, alkylene group, alkenylene group (example: -CH = CH-), alkynylene group (example: -C=C-), and arylene group), a divalent organic group (carbonate group (-O-CO-O-), carbodiimide group (-N = C = N-), acid anhydride group (-CO-O-CO-), ester group (-CO-O- or -O-CO-), carbonyl group (-CO-), imide ester group (-C(= NR^{C})-O- or -O-C (= NR^{C})-)) in the aforementioned group of functional groups P, or a group in which these are combined.

Examples of the combined group include -(divalent hydrocarbon group) -X¹¹¹-, -X¹¹¹-(divalent hydrocarbon group)-, -(divalent hydrocarbon group)-X¹¹¹-(divalent hydrocarbon group)-, -X¹¹¹-(divalent hydrocarbon group) -X¹¹¹- (divalent hydrocarbon group)-, or -(divalent hydrocarbon group)-X¹¹¹-(divalent hydrocarbon group)-X¹¹¹- and the like. In addition, -X¹¹¹-is -O-, -S-, -NR^{F}-, a divalent organic group in the aforementioned group of functional groups P, or a group in which these are combined. The total number of carbon atoms in the combined group is 1 to 20, and preferably 1 to 12.

The P¹ represents a monovalent organic group (boronic acid group (-B (OH)₂), aldehyde group (-CHO), isocyanate group (-N = C = O), isothiocyanate group (-N = C = S), cyanate group (-O-CN), acyl azide group, succinimide group, sulfonyl chloride group (-SO₂Cl), carboxylic acid chloride group (-COCl), onium group, aryl halide group, acid anhydride groups (including monovalent acid anhydride groups such as maleic acid anhydride, phthalic acid anhydride, pyromellitic acid anhydride, and trimellitic acid anhydridetrimellitic acid anhydride)), carboxylic acid group (-COOH), phosphonic acid group (-PO(OH)₂), phosphinic acid group (-HPO(OH)), phosphoric acid group (-OP(= O)(OH)₂), phosphoric acid ester group (-OP (= O) (OR^{B})₂), sulfonic acid group (-SO₃H), hydrogenated alkyl group, nitrile group (-CN), nitro group (-NO₂), alkoxysilyl group, acrylic group (-OCOCH₂ = CH₂), methacryl group (-OCOCH(CH₃) = CH₂), oxetanyl group, vinyl group (-CH = CH₂), alkynyl group (group in which one hydrogen atom is removed from alkyne in the aforementioned group of functional groups P. For example, an ethynyl group, a prop-2-in-1-yl group, and the like are included.), maleimide group, thiol group (-SH), hydroxyl group (-OH), and halogen atom (F atom, Cl atom, Br atom, and I atom)).

^{∗1} represents the bonding position with X.

General Formula (B2): ^{∗2}-L²-P²

In General Formula (B2), L² represents a divalent linking group containing a divalent organic group (carbonate group (-O-CO-O-), carbodiimide group (-N = C = N-), acid anhydride group (-CO-O-CO-), ester group (-CO-O- or -O-CO-), carbonyl group (-CO-), or imide ester group (-C(= NR^{C})-O- or -O-C(=NR^{C})-)) in the aforementioned group of functional groups P.

Examples of the L² include a divalent organic group in the aforementioned group of functional groups P, or a group obtained by combining a divalent organic group in the aforementioned group of functional groups P, and a linking group selected from the group consisting of -O-, -S-, -NR^{F}- (R^{F} represents a hydrogen atom or an alkyl group), and a divalent hydrocarbon group (for example, an alkylene group, an alkenylene group (example: -CH = CH-), an alkynylene group (example:-C=C-), and an arylene group).

Examples of the combined group include -(divalent hydrocarbon group)-X¹¹²- and the like. In addition, -X¹¹²- is a divalent organic group in the aforementioned group of functional groups P, or a group obtained by combining a divalent organic group in the aforementioned group of functional groups P and a divalent group selected from -O-, -S-, and -NR^{F}-. The total number of carbon atoms in the combined group is 1 to 20, and preferably 1 to 12.

The P² represents a monovalent organic group. The monovalent organic group represented by P² is not particularly limited, and examples thereof include an alkyl group. The number of carbon atoms in the alkyl group is, for example, 1 to 10, preferably 1 to 6, and more preferably 1 to 3.

^{∗2} represents the bonding position with X.

General Formula (B3): ^{∗31}-L³- ^{∗32}

In General Formula (B3), L³ represents a divalent linking group containing a divalent organic group (carbonate group (-O-CO-O-), a carbodiimide group (-N = C = N-), an acid anhydride group (-CO-O-CO-), an ester group (-CO-O- or -O-CO-), a carbonyl group (-CO-), or an imide ester group (-C(= NR^{C})-O- or -O-C(= NR^{C})-)) in the aforementioned group of functional groups P.

Examples of the L³ include a divalent organic group in the aforementioned group of functional groups P, or a group obtained by combining a divalent organic group in the aforementioned group of functional groups P, and a linking group selected from the group consisting of -O-, -S-, -NR^{F}- (R^{F} represents a hydrogen atom or an alkyl group), and a divalent hydrocarbon group (for example, an alkylene group, an alkenylene group (example: -CH = CH-), an alkynylene group (example: -C=C-), and arylene group).

Examples of the combined group include -(divalent hydrocarbon group)-X¹¹³-(divalent hydrocarbon group)-, -(divalent hydrocarbon group)-X¹¹³-, -X¹¹³-(divalent hydrocarbon group)-, -X¹¹³-(divalent hydrocarbon group) -X¹¹³-, and the like. In addition, -X¹¹³- is a divalent organic group in the aforementioned group of functional groups P, or a group obtained by combining a divalent organic group in the aforementioned group of functional groups P and a divalent group selected from -O-, -S-, and -NR^{F}-. The total number of carbon atoms in the combined group is 1 to 20, and preferably 1 to 12.

^{∗31} and ^{∗32} represent the bonding position with X. That is, the L³ forms a ring together with two different carbons in the condensed ring structure represented by the X.

General Formula (B4):

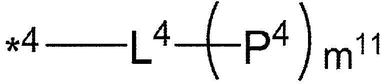

In General Formula (B4), L⁴ represents a linking group of m¹¹ + 1 valence.

m¹¹ represents an integer of 2 or more. An upper limit value of m¹¹ is not particularly limited, but is, for example, 100 or less, preferably 30 or less, more preferably 20 or less, and even more preferably 15 or less. A lower limit value of m¹¹ is not particularly limited, but is preferably 4 or more.

The linking group represented by L⁴ is not particularly limited, and examples thereof include an aromatic hydrocarbon ring of m¹¹ + 1 valence or a group represented by General Formula (M1).

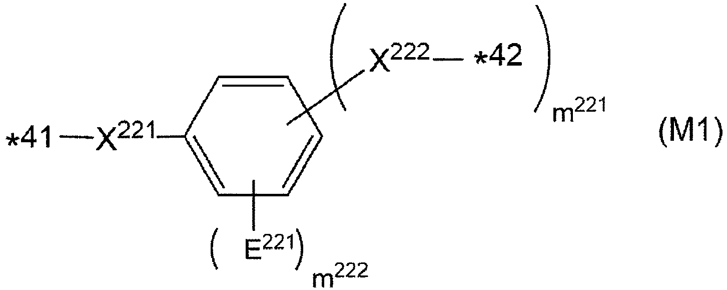

In General Formula (M1), X²²¹ and X²²² each independently represent a single bond or a divalent linking group. The divalent linking group represented by X²²¹ and X²²² is synonymous with the divalent linking group represented by L¹ in the aforementioned General Formula (B1).

E²²¹ represents a substituent. Examples of the substituent represented by E²²¹ include the groups exemplified in the substituent group Y.

m²²¹ represents an integer of 2 to 5. Among them, m²²¹ is preferably 2 or 3.

m²²² represents an integer of 0 to 3.

However, m²²¹ + m²²² represents an integer of 2 to 5.

^{∗41} represents the bonding position with X.

^{∗42} represents the bonding position with P⁴.

Among them, the group represented by General Formula (M1) is preferably the group represented by General Formula (M2).

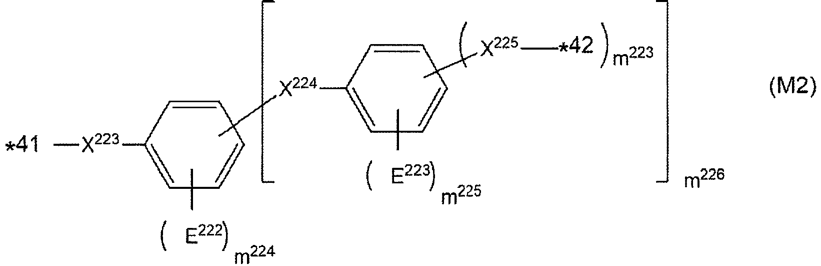

In General Formula (M2), X²²³, X²²⁴, and X²²⁵ each independently represent a single bond or a divalent linking group. The divalent linking group represented by X²²³, X²²⁴, and X²²⁵ is synonymous with the divalent linking group represented by L¹ in the aforementioned General Formula (B1).

E²²² and E²²³ each independently represent a substituent. Examples of the substituent represented by E²²² and E²²³ include the groups exemplified in the substituent group Y.

m²²³ represents an integer of 1 to 5. Among them, m²²³ is preferably 2 or 3.

m²²⁴ represents an integer of 0 to 3.

m²²⁵ represents an integer of 0 to 4.

m²²⁶ represents an integer of 2 to 5. Among them, m²²⁶ is preferably 2 or 3.

However, m²²⁴ + m²²⁶ represents an integer of 2 to 5. In addition, m²²³ + m²²⁵ represents an integer of 1 to 5.

^{∗41} represents the bonding position with X.

^{∗42} represents the bonding position with P⁴.

The P⁴ is synonymous with P¹ in the aforementioned General Formula (B1).

^{∗4} represents the bonding position with X.

### (Compound represented by General Formula (V2))

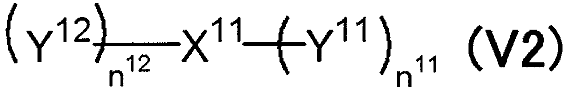

In General Formula (V2), X¹¹ represents an organic group of n¹¹ + n¹² valence having a condensed ring structure containing two or more rings selected from the group consisting of an aromatic hydrocarbon ring and an aromatic heterocyclic ring.

The X¹¹ represents an organic group of n¹¹ + n¹² valence (n¹¹ + n¹² are each independently an integer of 1 or more). n¹¹ and n¹² are not particularly limited as long as n¹¹ and n¹² are each independently an integer of 1 or more. In addition, an upper limit of n¹¹ + n¹² is not particularly limited, but is preferably an integer of 15 or less. Among them, the upper limit of n¹¹ + n¹² is preferably 2 to 8, more preferably 2 to 3, and even more preferably 2, from the viewpoint of more excellent dispersibility of the surface-modified inorganic substance.

Examples of the condensed ring structure containing two or more rings selected from the group consisting of an aromatic hydrocarbon ring and an aromatic heterocyclic ring in X¹¹ include the aforementioned structure, and the preferred aspect is also the same.

The organic group of n¹¹ + n¹² valence represented by X¹¹ is not particularly limited as long as it has a condensed ring structure containing two or more rings selected from the group consisting of aromatic hydrocarbon rings and aromatic heterocyclic rings, and from the viewpoint of more excellent effect of the present invention, a group formed by extracting n¹¹ + n¹² pieces of hydrogen atoms from a condensed ring containing two or more rings selected from the group consisting of an aromatic hydrocarbon ring and an aromatic heterocyclic ring is preferable.

The condensed structure may further have a substituent (for example, a substituent group Y) in addition to Y¹¹ and Y¹².

The Y¹¹ contains a functional group selected from the following group of functional groups Q. The functional group exemplified in the following group of functional groups Q corresponds to a functional group exemplified in the aforementioned group of functional groups P, which particularly tends to have excellent adsorptivity to an inorganic substance (in particular, inorganic nitride).

In addition, the Y¹² contains a functional group selected from the following group of functional groups R. The functional group exemplified in the following group of functional groups R corresponds to a functional group exemplified in the aforementioned group of functional groups P, which is a group having a function of easily accelerating the curing of the composition.

### (Group of functional groups Q)

A functional group selected from the group consisting of boronic acid group (-B(OH)₂), aldehyde group (-CHO), isocyanate group (-N = C = O), isothiocyanate group (-N = C = S), cyanate group (-O-CN), acyl azide group, succinate imide group, sulfonyl chloride group (-SO₂Cl), carboxylic acid chloride group (-COCl), onium group, carbonate group (-O-CO-O-), aryl halide group, carbodiimide group (-N = C = N-), acid anhydride group (-CO-O-CO-, or monovalent acid anhydride group such as maleic acid anhydride, phthalic acid anhydride, pyromellitic acid anhydride, and trimellitic acid anhydridetrimellitic acid anhydride), phosphonic acid group (-PO(OH)₂), phosphinic acid group (-HPO(OH)), phosphoric acid group (-OP(= O)(OH)₂), phosphoric acid ester group (-OP(= O)(OR^{B})₂), sulfonic acid group (-SO₃H), hydrogenated alkyl group, nitrile group (-CN), nitro group (-NO₂), ester group (-CO-O- or -O-CO-), carbonyl group (-CO-), imide ester group (-C(= NR_{C})-O- or -O-C(= NRc)-), and a halogen atom (fluorine atom, chlorine atom, bromine atom, and iodine atom).

### (Group of functional groups R)

A functional group selected from the group consisting of a carboxylic acid group (-COOH), an alkoxysilyl group, an acrylic group (-OCOCH₂ = CH₂), a methacryl group (-OCOCH(CH₃) = CH₂), an oxetanyl group, a vinyl group (-CH = CH₂), an alkynyl group (group obtained by excluding one hydrogen atom from alkyne. For example, an ethynyl group, a prop-2-in-1-yl group, and the like are included.), a maleimide group, a thiol group (-SH), a hydroxyl group (-OH), and an amino group.

In General Formula (V2), the Y¹¹ specifically represents a monovalent group represented by General Formula (C1) or a monovalent group represented by General Formula (C2), or in a case where n¹¹ represents an integer of 2 or more, represents a divalent group represented by General Formula (C3) in which a plurality of Y¹¹'s are bonded.

In other words, in a case where n¹¹ is 1, the Y¹¹ represents a monovalent group represented by General Formula (C1) or a monovalent group represented by General Formula (C2). In a case where n¹¹ represents an integer of 2 or more, the Y¹¹ represents a monovalent group represented by General Formula (C1) or a monovalent group represented by General Formula (C2), or represents a divalent group represented by General Formula (C3) in which a plurality of Y¹¹'s are bonded. In addition, in a case where n¹¹ is 2 or more, the plurality of Y¹¹'s may be the same or different.

In a case where the Y¹¹ represents a divalent group represented by General Formula (C3), the compound represented by General Formula (V2) is represented by General Formula (V4).

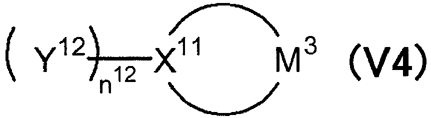

In General Formula (V4), X¹¹, Y¹², and n¹² are synonymous with X¹¹, Y¹², and n¹² in the aforementioned General Formula (V2). In addition, M³ is synonymous with M³ in General Formula (C3) described later.

General Formula (C1): ^{∗1}-M¹-Q¹

In General Formula (C1), M¹ represents a single bond or a divalent linking group. The divalent linking group represented by M¹ is synonymous with the aforementioned L¹, and the preferred aspect is also the same.

The Q¹ represents a monovalent organic group (boronic acid group (-B(OH)₂), aldehyde group (-CHO), isocyanate group (-N = C = O), isothiocyanate group (-N = C = S), cyanate group (-O-CN), acyl azide group, succinimide group, sulfonyl chloride group (-SO₂Cl), carboxylic acid chloride group (-COCl), onium group, aryl halide group, acid anhydride group (including monovalent acid anhydride group such as maleic acid anhydride, phthalic acid anhydride, pyromellitic acid anhydride, and trimellitic acid anhydridetrimellitic acid anhydride), phosphonic acid group (-PO(OH)₂), phosphinic acid group (-HPO(OH)), phosphoric acid group (-OP(= O) (OH)₂), phosphoric acid ester group (-OP(= O)(OR^{B})₂), sulfonic acid group (-SO₃H), an hydrogenated alkyl group, a nitrile group (-CN), a nitro group (-NO₂), or a halogen atom (fluorine atom, chlorine atom, bromine atom, and iodine atom)) in the aforementioned group of functional groups Q. ^{∗1} represents the bonding position with X¹¹.

General Formula (C2): ^{∗2}-M²-Q²

In General Formula (B2), M² is synonymous with the aforementioned L², and the preferred aspect is also the same. The Q² represents a monovalent organic group. The monovalent linking group represented by Q² is synonymous with the aforementioned P², and the preferred aspect is also the same. ^{∗2} represents the bonding position with X¹¹.

General Formula (C3): ^{∗31}-M³-^{∗32}

In General Formula (B3), M³ is synonymous with the aforementioned L3, and the preferred aspectis also the same. ^{∗31} and ^{∗32} represent the bonding position with X¹¹. That is, the M³ forms a ring together with two different carbons in the condensed ring structure represented by X¹¹.

The Y¹² represents a monovalent group represented by General Formula (D1) or a monovalent group represented by General Formula (D2).

General Formula (Dl): ^{∗1}-W¹-R¹

In General Formula (Dl), W¹ represents a single bond or a divalent linking group. R¹ represents a carboxylic acid group, an alkoxysilyl group, an acrylic group, a methacryl group, an oxetanyl group, a vinyl group, an alkynyl group, a maleimide group, a thiol group, a hydroxyl group, or an amino group. ^{∗1} represents the bonding position with X¹¹. The R¹ represents the functional group exemplified in the aforementioned group of functional groups R.

The divalent linking group represented by W¹ is synonymous with the aforementioned L¹, and the preferred aspect is also the same.

^{∗1} represents the bonding position with X¹¹.

General Formula (D2):

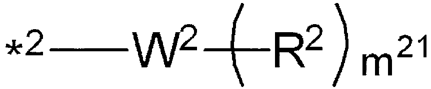

In General Formula (D2), W² represents a linking group of m²¹ + 1 valence.

m²¹ represents an integer of 2 or more. An upper limit value of m²¹ is not particularly limited, but is, for example, 100 or less, preferably 30 or less, more preferably 20 or less, and even more preferably 15 or less. A lower limit value of m²¹ is not particularly limited, but is preferably 4 or more.

R² represents a carboxylic acid group, an alkoxysilyl group, an acrylic group, a methacryl group, an oxetanyl group, a vinyl group, an alkynyl group, a maleimide group, a thiol group, a hydroxyl group, or an amino group. The R² represents the functional group exemplified in the aforementioned group of functional groups R.

The linking group of m²¹ + 1 valence represented by W² is synonymous with the aforementioned L⁴, and the preferred aspect is also the same.

^{∗2} represents the bonding position with X¹¹.

A molecular weight of the surface modifier A is, for example, 150 or more, from the viewpoint of more excellent dispersibility of the surface-modified inorganic nitride, is preferably 200 or more, and from the viewpoint of solubility, is preferably 2,000 or less, and more preferably 1,000 or less.

### <Surface modifier B>

In addition, the surface modifier is preferably the surface modifier B described below.

The surface modifier B is a compound represented by General Formula (W1).

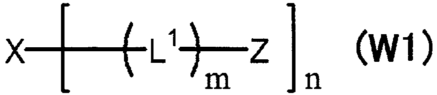

In General Formula (W1), X represents a benzene ring group or a heterocyclic group which may have a substituent. That is, X represents a benzene ring group which may have a substituent, or a heterocyclic group which may have a substituent.

The heterocyclic group is not particularly limited, and examples thereof include an aliphatic heterocyclic group and an aromatic heterocyclic group. Examples of the aliphatic heterocyclic group include a 5-membered ring group, a 6-membered ring group, a 7-membered ring group, or a condensed ring group thereof. In addition, examples of the aromatic heterocyclic group include a 5-membered ring group, a 6-membered ring group, a 7-membered ring group, or a condensed ring group thereof.

The condensed ring group may contain a ring group other than the heterocyclic group such as a benzene ring group.

Specific examples of the aliphatic heterocyclic group are not particularly limited, and examples thereof include an oxolane ring group, an oxane ring group, a piperidine ring group, a piperazine ring group, and the like.

Examples of the hetero atom contained in the aromatic heterocyclic group include a nitrogen atom, an oxygen atom, a sulfur atom, and the like. The number of carbon atoms of the aromatic heterocyclic group is not particularly limited, but is preferably 3 to 20.

Specific examples of the aromatic heterocyclic group are not particularly limited, and examples thereof include a furan ring group, a thiophene ring group, a pyrrole ring group, an oxazole ring group, an isoxazole ring group, an oxadiazole ring group, a thiazole ring group, an isothiazole ring group, a thiadiazole ring group, an imidazole ring group, a pyrazole ring group, a triazole ring group, a furazan ring group, a tetrazole ring group, a pyridine ring group, a pyridazine ring group, a pyrimidine ring group, a pyrazine ring group, a triazine ring group, a tetrazine ring group, a benzofuran ring group, an isobenzofuran ring group, a benzothiophene ring group, an indole ring group, an indoline ring group, an isoindole ring group, a benzoxazole ring group, a benzothiazole ring group, an indazole ring group, a benzimidazole ring group, a quinoline ring group, an isoquinoline ring group, a cinnoline ring group, a phthalazine ring group, a quinazoline ring group, a quinoxaline ring group, a dibenzofuran ring group, a dibenzothiophene ring group, a carbazole ring group, an acridine ring group, a phenanthridine ring group, a phenanthroline ring group, a phenazine ring group, a naphthyridine ring group, a purine ring group, a pteridine ring group, and the like.

The heterocyclic group represented by X is preferably an aromatic heterocyclic group.

Among them, X is preferably a benzene ring group or a triazine ring group, and more preferably a triazine ring group.

In a case where X has a substituent, the substituent preferably contains a specific functional group B described later.

In General Formula (W1), n represents an integer of 3 to 6, and n groups represented by [-(L¹)ₘ-Z] are bonded to X.

In General Formula (W1), the group represented by [-(L¹)ₘ-Z] is a group that is directly bonded to X.

A plurality of L¹'s each independently represent an arylene group, an ester group (-CO-O- or -O-CO-), an ether group (-O-), a thioester group (-SO-O- or -O-SO-), a thioether group (-S-), a carbonyl group (-CO-), -NR^{N}-, an azo group (-N = N-), which may have a substituent, or an unsaturated hydrocarbon group which may have a substituent.

In addition, R^{N} represents an organic group having 1 to 10 carbon atoms which may have a hydrogen atom or a substituent.

The number of carbon atoms of the arylene group represented by L₁ is preferably 6 to 20, more preferably 6 to 10, and even more preferably 6. Among them, the arylene group is preferably a phenylene group.

In a case where the arylene group is a phenylene group, a position at which the arylene group is bonded to an adjacent group (including a case where two groups of X, L₁, and Z are both L₁) is not particularly limited, the arylene group may be bonded at any of the ortho position, meta position, and para position, and is preferably bonded at the para position. The arylene group may or may not have a substituent, and preferably does not have a substituent. In a case where the arylene group has a substituent, the substituent preferably contains a specific functional group B described later.

In a case where L₁ is an ester group, the carbon atom in the ester group is preferably present on the X side. In a case where L₁ is a thioester group, the sulfur atom in the thioester group is preferably present on the X side.

An unsaturated hydrocarbon group represented by L₁ may be linear or branched, and may have a cyclic structure. The number of carbon atoms of the unsaturated hydrocarbon group is preferably 2 to 10, more preferably 2 to 5, even more preferably 2 to 3, and particularly preferably 2. However, the number of carbon atoms does not include the number of carbon atoms contained in the substituent that the unsaturated hydrocarbon group has. The unsaturated bond contained in the unsaturated hydrocarbon group may be a double bond (-C = C-), or may be a triple bond (-C=C-). The unsaturated hydrocarbon group may or may not have a substituent, and preferably does not have a substituent. In a case where the unsaturated hydrocarbon group has a substituent, the substituent preferably contains a specific functional group B.

In a case where R^{N} of -NR^{N}- represented by L₁ is an organic group having 1 to 10 carbon atoms which may have a substituent, the R^{N} is preferably an alkyl group having 1 to 10 carbon atoms which may have a substituent, preferably an alkyl group having 1 to 5 carbon atoms which may have a substituent, and preferably an alkyl group having 1 to 3 carbon atoms which may have a substituent. The alkyl group may be linear or branched, and may have a cyclic structure. The R^{N} is preferably a hydrogen atom.

m represents an integer of 0 or more. m is preferably an integer of 0 to 10, more preferably an integer of 0 to 5, even more preferably an integer of 0 to 2, and particularly preferably an integer of 1 to 2.

In a case where m is 0, Z is directly bonded to X.

In a case where m is 1, L¹ is preferably an arylene group, an ester group, an ether group, a thioester group, a thioether group, a carbonyl group, -NR^{N}-, and an azo group, which may have a substituent, or an unsaturated hydrocarbon group which may have a substituent, more preferably an arylene group, an ester group, an ether group, a carbonyl group, which may have a substituent, or an unsaturated hydrocarbon group which may have a substituent, and even more preferably an ester group, an ether group, a carbonyl group, or an unsaturated hydrocarbon group which may have a substituent.

In a case where m is 2, [-(L¹)ₘ-Z] is [-L¹-L¹-Z], and L¹ bonded to X is preferably an arylene group which may have a substituent. In this case, L¹ bonded to Z is preferably an ester group, an ether group, a thioester group, a thioether group, a carbonyl group, -NR^{N}-, an azo group, or an unsaturated hydrocarbon group which may have a substituent, and more preferably an ester group, or an unsaturated hydrocarbon group which may have a substituent.

In a case where m is larger than 2, the plurality of L¹'s present in [-(L¹)ₘ-Z] may be the same or different, but each of L¹ bonded to each other is preferably different.

-(L¹)ₘ- in General Formula (W1) is preferably a group represented by General Formula (Lq). That is, the group represented by [-(L¹)ₘ-Z] is preferably the group represented by [-L^{a}-Z],

General Formula (Lq) -L^{a}-

L^{a} represents a single bond, -O-, -CO-, -COO-, a phenylene group, -C = C-, -C=C-, -phenylene group-COO-, or -phenylene group-C=C-.

Z represents an aryl group or a heterocyclic group which may have a substituent. That is, Z represents an aryl group which may have a substituent, or a heterocyclic group which may have a substituent.

The number of carbon atoms of the aryl group represented by Z is preferably 6 to 20, more preferably 6 to 14, and even more preferably 6. Examples of the aryl group include a phenyl group, a naphthyl group, an anthracenyl group, and the like.

Examples of the heterocyclic group represented by Z similarly include the aforementioned heterocyclic group in which X can be formed. In addition, the heterocyclic group represented by Z preferably exhibits aromaticity.

Among them, Z is preferably an aryl group, more preferably a phenyl group or an anthracenyl group, and even more preferably a phenyl group.

Z preferably has a substituent, and more preferably the substituent contains a specific functional group B described later. The number of substituents contained in one Z is preferably 0 to 5, more preferably 0 to 2, and even more preferably 1 to 2.

At least one of the plurality of Z's preferably has a substituent containing the specific functional group B.

The surface modifier B preferably has 1 or more specific functional groups B contained in substituents of the plurality of Z's, more preferably 2 or more, and even more preferably 3 or more thereof in total.

An upper limit of the total number of the specific functional groups B contained in the substituents of the plurality of Z's contained in the surface modifier B is not particularly limited, but is preferably 15 or less, more preferably 10 or less, and even more preferably 8 or less.

As described above, in General Formula (W1), n represents an integer of 3 to 6. Each group of the plurality of [-(L¹)ₘ-Z] may be the same or different.

That is, in General Formula (W1), a plurality of m's may be the same or different, and in a case where a plurality of L¹'s are present, the plurality of L¹'s may be the same or different, and the plurality of Z's may be the same or different.

The plurality of m's are preferably all the same. In addition, the plurality of m's preferably each represents an integer of 1 or more, and also preferably each represents an integer of 2 or more.

The plurality of [-(L¹)ₘ-Z] preferably has all the same configuration except for the substituents of Z, and preferably has all the same configuration including the substituents of Z's.

n is preferably 3 or 6.

In a case where there is a group in [(-(L¹)ₘ-Z)] that can be either (L¹)ₘ or Z, the group is (L¹ₘ. For example, in a case where [-(L¹)ₘ-Z] is [-benzene ring group-benzene ring group-halogen atom], the benzene ring group on the left side is (L¹)ₘ, not Z. More specifically, in the case, "m = 1, L¹ is a phenylene group (arylene group), and Z is a phenyl group (aryl group) having a halogen atom as a substituent", and not "m = 0, and Z is a phenyl group (aryl group) having an aryl halide group as a substituent".

In addition, the surface modifier B represented by General Formula (W1) preferably has four or more benzene ring groups. For example, the surface modifier B preferably has a triphenylbenzene structure.

In addition, the surface modifier B represented by General Formula (W1) preferably has a total of four or more benzene ring groups and triazine ring groups. In this case, for example, X is preferably a triazine ring group.

### (Specific functional group B)

The surface modifier B preferably has one or more specific functional groups B, and more preferably two or more thereof.

The specific functional group B is a group selected from the group consisting of a boronic acid group, an aldehyde group, a hydroxyl group, a carboxylic acid group, an isocyanate group, an isothiocyanate group, a cyanate group, an acyl azide group, a succinate imide group, a sulfonyl chloride group, a carboxylic acid chloride group, an onium group, a carbonate group, an aryl halide group, a carbodiimide group, an acid anhydride group (monovalent acid anhydride group), a phosphonic acid group, a phosphinic acid group, a phosphoric acid group, a phosphoric acid ester group, a sulfonic acid group, a halogen atom, a hydrogenated alkyl group, a nitrile group, a nitro group, an imide ester group, an alkoxycarbonyl group, an alkoxysilyl group, an acryloyl group, a methacryloyl group, an oxetanyl group, a vinyl group, an alkynyl group, a maleimide group, a thiol group, an amino group, and a silyl group.

Among them, as the specific functional group B, a hydroxyl group, an amino group, an acid anhydride group, a thiol group, a carboxylic acid group, an acryloyl group, a methacryloyl group, or a vinyl group is preferable.

The hydroxyl group is intended to be a group in which the -OH group is directly bonded to a carbon atom. For example, it is assumed that the -OH group present in the form contained in the carboxylic acid group (-COOH) is not a hydroxyl group.

The alkoxycarbonyl group is not particularly limited as long as the alkoxycarbonyl group is a group represented by -CO-O-R^{f}. The R^{f} represents an alkyl group (including any of linear, branched, and cyclic).

The number of carbon atoms in the alkyl group represented by R^{f} is, for example, 1 to 10, preferably 1 to 6, and more preferably 1 to 3.

In addition, among the specific functional groups B, the functional group that overlaps with the specific functional group A are as described for the specific functional group A.

In a case where the surface modifier B has a plurality of specific functional groups B, the plurality of specific functional groups B may be the same or different.

A position at which the specific functional group B is present is not particularly limited, and for example, the specific functional group B may be contained in the substituent of X in General Formula (W1), may be contained in a substituent of L¹ in a case of being present in an arylene group or an unsaturated hydrocarbon group, or may be contained in a substituent of Z.

The specific functional group B may be bonded to a group other than the specific functional group B to form one substituent.

In addition, a plurality of specific functional groups B may be contained in one substituent.

As the substituent containing the specific functional group B, a group represented by General Formula (Rx), a group represented by General Formula (Ry), or a group represented by General Formula (Rz) is preferable.

General Formula (Rx) -Lₓ1-Qₓ

General Formula (Ry) -Ly¹-Qy

General Formula (Rz) -L_{z}1-Sz- (Lz²-Qz)ₛ

In General Formula (Rx), Lx¹ represents a single bond or a divalent linking group.

The divalent linking group is not particularly limited, but for example, represents a divalent linking group obtained by combining any of one or two or more selected from the group consisting of -O-, -CO-, -NH-, and a divalent hydrocarbon group.

The divalent hydrocarbon group may further have a substituent (for example, the group exemplified in the substituent group Y).

Examples of the divalent hydrocarbon group include an alkylene group, an alkenylene group (example: -CH = CH-), an alkynylene group (example: -C=C-), and an arylene group (example: phenylene group). The alkylene group may be any of linear, branched or cyclic, but is preferably linear. In addition, the number of carbon atoms thereof is preferably 1 to 10, more preferably 1 to 6, and even more preferably 1 to 4.

As Lx¹, a single bond, -AL-, -O-, -O-CO-, -O-AL-, -AL-CO-, -O-AL-O-, -O-CO-AL-, - CO-O-AL-, -AL-NH-CO-, -O-AL-O-AL-, -CO-O-AL-O-, or -O-AL-O-Ar- is preferable.

The AL represents an alkylene group having 1 to 10 carbon atoms (the number of carbon atoms is preferably 1 to 6, and more preferably 1 to 4).

The Ar represents an arylene group having 6 to 20 carbon atoms (preferably a phenylene group). In a case where Lx¹ is "-O-AL-O-Ar-", Ar in "-O-AL-O-Ar-" is bonded to Qx.

Qx represents a monovalent specific functional group B. Specifically, an aldehyde group, a hydroxyl group, a carboxylic acid group, an isocyanate group, an isothiocyanate group, a cyanate group, an acyl azide group, a succinimide group, a sulfonyl chloride group, a carboxylic acid chloride group, an onium group, an aryl halide group, a phosphonic acid group, phosphinic acid group, phosphoric acid group, sulfonic acid group, phosphoric acid ester group, halogen atom, acid anhydride group, hydrogenated alkyl group nitrile group, nitro group, alkoxycarbonyl group, alkoxysilyl group, acryloyl group, methacryloyl group, an oxetanyl group, a vinyl group, an alkynyl group, a maleimide group, a thiol group, an amino group, an epoxy group, and a silyl group.

In General Formula (Ry), Ly¹ represents a divalent linking group containing a carbodiimide group, a carbonate group, or an imide ester group. The divalent linking group represented by Ly¹ may contain a carbodiimide group, a carbonate group, or an imide ester group, and may be combined with another linking group. Examples of other linking groups include an alkylene group. For example, Ly¹ may be -alkylene group-Ly³-alkylene group. Ly³ represents a carbodiimide group, a carbonate group, or an imide ester group.

The Qy represents a monovalent organic group. The monovalent organic group represented by Qy is not particularly limited, and examples thereof include an alkyl group. The number of carbon atoms in the alkyl group is, for example, 1 to 10, preferably 1 to 6, and more preferably 1 to 3.

In General Formula (Rz), s represents an integer of 2 to 3. s is preferably 2.

Lz¹ represents a group that can be represented by Lx¹, and the preferred conditions are the same.

The plurality of Lz²'s each independently represents a single bond or a divalent linking group.

The divalent linking group is not particularly limited, and for example, represents a divalent linking group obtained by combining any one or two or more selected from the group consisting of -O-, -CO-, -NH-, and a divalent hydrocarbon group.

The divalent hydrocarbon group may further have a substituent (for example, the group exemplified in the substituent group Y).

Examples of the divalent hydrocarbon group include an alkylene group, an alkenylene group (example: -CH = CH-), an alkynylene group (example: -C≡C-), and an arylene group (example: phenylene group). The alkylene group may be any of linear, branched or cyclic, but is preferably linear. In addition, the number of carbon atoms thereof is preferably 1 to 10, more preferably 1 to 6, and even more preferably 1 to 4.

As Lz², a single bond, -AL-, -O-, -O-CO-, -O-AL-, -AL-CO-, -O-AL-O-, -O-CO-AL-, -CO-O-AL-, -AL-NH-CO-, -O-AL-O-AL-, -CO-O-AL-O-, -O-AL-O-Ar-, or -O-Ar- is preferable.

The AL represents an alkylene group having 1 to 10 carbon atoms (the number of carbon atoms is preferably 1 to 6, and more preferably 1 to 4).

The Ar represents an arylene group having 6 to 20 carbon atoms (preferably a phenylene group).

Sz represents a linking group of (s + 1) valence.

As Sz, an aromatic ring group having (s + 1) valence is preferable. The aromatic ring group may be an aromatic hydrocarbon ring group or an aromatic heterocyclic group, and is preferably a benzene ring group or a triazine ring group.

Qz represents a monovalent specific functional group B.

The plurality of Qz each independently represents a group that can be represented by the Qx, and the preferred conditions are the same.

### (Compound represented by General Formula (W2))

The surface modifier B is preferably a compound represented by General Formula (W2).

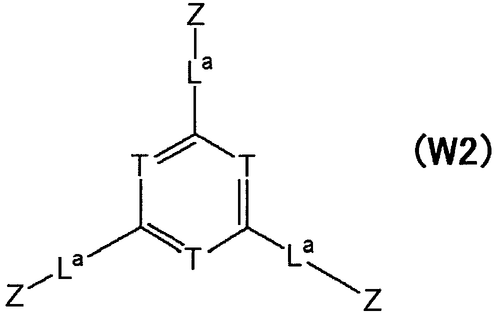

In General Formula (W2), the definitions of L^{a} and Z are as described above. The plurality of L^{a}'s may be the same or different. The plurality of Z's may be the same or different.

T each independently represents -CR^{a} = or -N =. R^{a} represents a hydrogen atom, a monovalent specific functional group B, or -L^{a}-Z. The definitions of L^{a} and Z are as described above.

For example, in a case where all T's are -CR^{a} = and all R^{a}'s are -L^{a}-Z, the compound represented by General Formula (W2) has six groups represented by -L^{a}-Z.

In addition, in a case where all T's are -N =, the compound represented by General Formula (W2) has a triazine ring.

(Compound represented by General Formula (W3)

As the compound represented by General Formula (W2), the compound represented by General Formula (W3) is preferable.

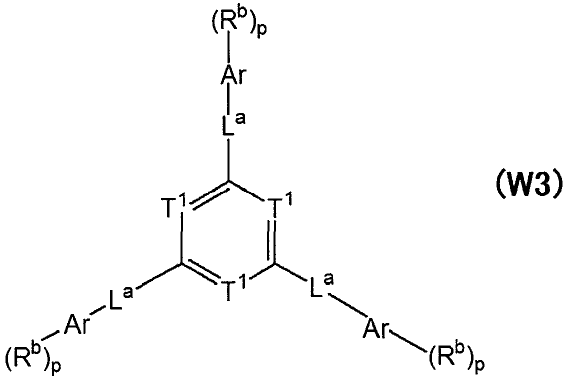

In General Formula (W3), the definition of L^{a} is as described above. The plurality of L^{a}'s may be the same or different.

Ar each independently represents an aryl group. Preferred aspects of the aryl group include an aryl group represented by Z.

R^{b} each independently represents a substituent containing a specific functional group B. The definition of the specific functional group B is as described above. In addition, as the substituent containing a specific functional group B, a group represented by General Formula (Rx), a group represented by General Formula (Ry), or a group represented by General Formula (Rz) is preferable.

p each independently represents an integer of 0 to 5. p is preferably 0 to 2. Among them, an aspect 1 in which two p's out of three p's in General Formula (W3) is 0 and one p is 1, or an embodiment 2 in which three p's are all 1 is preferable.

### In General Formula (W3), T¹ each independently represents -CR^{c}= or -N=. R^{c} represents a hydrogen atom, a monovalent specific functional group B, or -L^{a}-Ar-(R^{b})ₚ. The definitions of L^{a}, Ar, R^{b}, and p are as described above.

A molecular weight of the surface modifier B is preferably 300 or more, and more preferably 350 or more, from the viewpoint of being more excellent in the dispersibility of the surface-modified inorganic nitride. In addition, the molecular weight of the surface modifier B is preferably 3,000 or less, and more preferably 2,000 or less, from the viewpoint of excellent solubility.

The surface modifier B can be synthesized according to a known method.

### <Other surface modifiers>

In addition, the composition also preferably contains an organic silane molecule (preferably a compound having an alkoxysilyl group) as a surface modifier (preferably in a case where the inorganic substance contains an inorganic oxide (aluminum oxide and the like)). Examples of the organic silane molecule include surface modifier A, surface modifier B, and other surface modifiers that do not fall under any of these.

Examples of the organic silane molecule as the other surface modifier include 3 -aminopropyltriethoxysilane, 3 -(2-aminoethyl)aminopropyltriethoxysilane, 3 -aminopropyltrimethoxysilane, 3 -(2-aminoethyl)aminopropyltrimethoxysilane, N-phenyl-3-aminopropyltrimethoxysilane, 3-mercaptotriethoxysilane, 3-ureidopropyltriethoxysilane, and the like.

One kind of the surface modifier may be used singly, or two or more kinds thereof may be used.

In a case where the composition contains a surface modifier, a mass ratio of the content of the surface modifier to a content of the inorganic substance (content of the surface modifier/ content of the inorganic substance) is preferably 0.0001 to 10, and more preferably 0.0001 to 5. In addition, the mass ratio of the total contents of the surface modifier A and the surface modifier B to the content of the inorganic nitride (preferably boron nitride and/or aluminum nitride) (total content of the surface modifier A and the surface modifier B/content of inorganic nitride) is preferably 0.0001 to 10, and more preferably 0.0001 to 5.

A mass ratio of the content of organic silane molecules as surface modifiers (preferably organic silane molecules, which are other surface modifiers) to the content of inorganic oxides (preferably aluminum oxide) (content of organic silane molecules/content of the inorganic oxide) is preferably 0.0001 to 10, and more preferably 0.001 to 5.

### [Curing accelerator]

The composition according to the embodiment of the present invention may further contain a curing accelerator.

The kind of the curing accelerator is not limited, and examples thereof include triphenylphosphine, 2-ethyl-4-methylimidazole, boron trifluoride amine complex, 1-benzyl-2-methylimidazole, a compound described in paragraph 0052 of JP2012-67225A, and the like.

One kind of the curing accelerators may be used singly, or two or more kinds thereof may be used.

In a case where the composition contains a curing accelerator, a mass ratio of the content of the curing accelerator to the content of the epoxy compound (content of curing accelerator/content of epoxy compound) is preferably 0.0001 to 10, and more preferably 0.001 to 5.

### [Polymerization initiator]

The composition according to the embodiment of the present invention may contain a polymerization initiator. Among them, in a case where the composition according to the embodiment of the present invention contains a compound X1 containing a specific functional group selected from the group consisting of an alkenyl group, an acrylate group, and a methacrylate group, the composition according to the embodiment of the present invention preferably contains a polymerization initiator.

The polymerization initiator is not particularly limited, and a known polymerization initiator can be used. Examples of the polymerization initiator include a photopolymerization initiator, a thermal polymerization initiator, and the like, and a photopolymerization initiator is preferable. As the polymerization initiator, a so-called radical polymerization initiator is preferable.

In a case where the composition according to the embodiment of the present invention contains a polymerization initiator, the content of the polymerization initiator in the composition is not particularly limited, but is preferably 0.5% to 15% by mass, more preferably 1.0% to 10% by mass, and even more preferably 1.5% to 8.0% by mass, with respect to the content of the compound X. One kind of the polymerization initiators may be used singly, or two or more kinds thereof may be used in combination. In a case where two or more kinds of polymerization initiators are used in combination, the total content is preferably within the above range.

### [Dispersant]

The composition according to the embodiment of the present invention may further contain a dispersant.

In a case where the composition contains a dispersant, the dispersibility of the inorganic substance in the composition is improved, and thus more excellent thermal conductivity and adhesiveness can be achieved.

The dispersant can be appropriately selected from commonly used dispersants. Examples thereof include DISPERBYK-106 (produced by BYK-Chemie GmbH), DISPERBYK-111 (produced by BYK-Chemie GmbH), ED-113 (produced by Kusumoto Chemicals, Ltd.), AJISPER PN-411 (produced by Ajinomoto Fine-Techno Co., Inc.), and REB122-4 (produced by Showa Denko Materials Co., Ltd.).

One kind of the dispersants may be used singly, or two or more kinds thereof may be used.

In a case where the composition contains a dispersant, a mass ratio of the content of the dispersant to the content of the inorganic substance (content of dispersant/content of inorganic substance) is preferably 0.0001 to 10, and more preferably 0.001 to 5.

### [Solvent]

The composition according to the embodiment of the present invention may further contain a solvent.

A kind of the solvent is not particularly limited, and an organic solvent is preferable. Examples of the organic solvent include cyclopentanone, cyclohexanone, ethyl acetate, methyl ethyl ketone, dichloromethane, tetrahydrofuran, and the like.

In a case where the composition contains a solvent, a content of the solvent is preferably an amount such that the concentration of the solid content in the composition is 20% to 90% by mass, more preferably an amount such that the concentration is 30% to 80% by mass, and even more preferably an amount such that the concentration is 40% to 80% by mass.

### [Method for producing composition]

A method for producing the composition is not particularly limited, known methods can be adopted, and for example, the composition can be produced by mixing the aforementioned various components. In a case of mixing, the various components may be mixed at a time, or may be mixed sequentially.

A method for mixing the components is not particularly limited, and known methods can be used. A mixing device used for the mixing is preferably a disperser in liquid, and examples thereof include a rotating and revolving mixer, a stirrer such as a high-speed rotating shear-type stirrer, a colloid mill, a roll mill, a high-pressure injection-type disperser, an ultrasonic disperser, a beads mill, and a homogenizer. One kind of the mixing devices may be used singly, or two or more kinds thereof may be used. A deaeration treatment may be performed before and after the mixing and/or simultaneously with the mixing.

### [Method for curing composition]

The composition according to the embodiment of the present invention is subjected to a curing treatment to obtain a thermally conductive material according to the embodiment of the present invention.

A method for curing the composition is not particularly limited, but a thermal curing reaction is preferable.

A heating temperature during the thermal curing reaction is not particularly limited. For example, the heating temperature may be appropriately selected within a range of 50°C to 250°C. In addition, in a case where the thermal curing reaction is performed, a heating treatment at different temperatures may be performed a plurality of times.

The curing treatment is preferably performed on the composition which is formed in a film shape or a sheet shape. Specifically, for example, the composition may be applied to form a film, and a curing reaction may be performed.

In a case where the curing treatment is performed, the composition is preferably applied onto a substrate to form a coating film, and then to cure the coating film. In this case, a different substrate is further brought into contact with the coating film formed on the substrate, and then the curing treatment may be performed. A cured substance (thermally conductive material) obtained after the curing may or may not be separated from one or both of the substrates.

In addition, in a case where the curing treatment is performed, the composition is applied onto different substrates to form respective coating films, and the curing treatment may be performed in a state where the obtained coating films are in contact with each other. A cured substance (thermally conductive material) obtained after the curing may or may not be separated from one or both of the substrates.

At a time of the curing treatment, press working may be performed. A press used for press working is not limited, and for example, a flat plate press or a roll press may be used.

In a case where the roll press is used, for example, preferably, a substrate with a coating film, which is obtained by forming a coating film on a substrate, is sandwiched between a pair of rolls in which two rolls face each other, and while rotating the pair of rolls to cause the substrate with a coating film to be passed, a pressure is applied in a film thickness direction of the substrate with a coating film. In the substrate with a coating film, a substrate may be present on only one surface of the coating film, or a substrate may be present on both surfaces of the coating film. The substrate with a coating film may be passed through the roll press only once or a plurality of times.

Only one of the treatment by the flat plate press and the treatment by the roll press may be carried out, or both may be carried out.

In addition, the curing treatment may be completed at a time at which the composition is in a semi-cured state. The thermally conductive material according to the embodiment of the present invention in a semi-cured state may be arranged so as to be in contact with the device or the like to be used, then further cured by heating and the like, and the main curing may be performed. It is also preferable that the device and the thermally conductive material according to the embodiment of the present invention adhere to each other by heating and the like at the time of the main curing.

For the preparation of the thermally conductive material including a curing reaction, "Highly Thermally Conductive Composite Material" (CMC Publishing CO., LTD., written by Yoshitaka TAKEZAWA) can be referred to.

A shape of the thermally conductive material is not particularly limited, and the thermally conductive material can be molded into various shapes according to the use. Examples of a typical shape of the molded thermally conductive material include a sheet shape.

That is, the thermally conductive material according to the embodiment of the present invention is preferably a thermally conductive sheet.

In addition, the thermally conductive properties of the thermally conductive material according to the embodiment of the present invention are preferably isotropic rather than anisotropic.

The thermally conductive material preferably has insulating properties (electrical insulating properties). In other words, the composition according to the embodiment of the present invention is preferably a thermally conductive insulating composition.

For example, a volume resistivity of the thermally conductive material at 23°C and a relative humidity of 65% is preferably 10¹⁰ Ω·cm or greater, more preferably 10¹² Ω·cm or greater, even more preferably 10¹⁴ Ω·cm or greater, and particularly preferably 10¹⁶ Ω·cm or greater. An upper limit thereof is not particularly limited, but is generally 10¹⁸ Ω·cm or less.

### [Use of thermally conductive material]

The thermally conductive material according to the embodiment of the present invention can be used as a heat dissipation material such as a heat dissipation sheet, and can be used for dissipating heat from various devices. More specifically, a device with a thermally conductive layer is prepared by arranging a thermally conductive layer, which contains the thermally conductive material according to the embodiment of the present invention, on a device, and thus the heat generated from the device can be efficiently dissipated by the thermally conductive layer.

The thermally conductive material according to the embodiment of the present invention has sufficient thermally conductive properties and high heat resistance, and thus is suitable for dissipating heat from a power semiconductor device used in various electrical machines such as a personal computer, a general household electric appliance, and an automobile.

In addition, the thermally conductive material according to the embodiment of the present invention has sufficient thermally conductive properties even in a semi-cured state, and thus can also be used as a heat dissipation material which is arranged in a portion where light for photocuring is hardly reached, such as a gap between members of various devices. In addition, the thermally conductive material also has excellent adhesiveness, and thus can also be used as an adhesive having thermally conductive properties.

The thermally conductive material according to the embodiment of the present invention may be used in combination with members other than the members formed of the present composition.

For example, a sheet-shaped thermally conductive material (thermally conductive sheet) may be combined with a sheet-shaped support in addition to the layer formed of the present composition.

Examples of the sheet-shaped support include a plastic film, a metal film, or a glass plate. Examples of a material for the plastic film include polyester such as polyethylene terephthalate (PET), polycarbonate, an acrylic resin, an epoxy resin, polyurethane, polyamide, polyolefin, a cellulose derivative, and silicone. Examples of the metal film include a copper film.

### Examples

Hereinafter, the present invention will be described in more detail based on Examples. The materials, the amount and proportion of the materials used, the details of treatments, the procedure of treatments, and the like shown in the following Examples can be appropriately changed within a range that does not depart from the gist of the present invention. Accordingly, the scope of the present invention is not limitedly interpreted by the following Examples.

### [Preparation and evaluation of composition]

### [Various components]

Various components used in Examples or Comparative Examples will be shown below.

### <Curing agent>

### (Phenolic compound)

Phenolic compounds used in Examples or Comparative Examples will be shown below.

A phenolic compound A-3 is MEH-7500 produced by Meiwa Plastic Industries, Ltd.

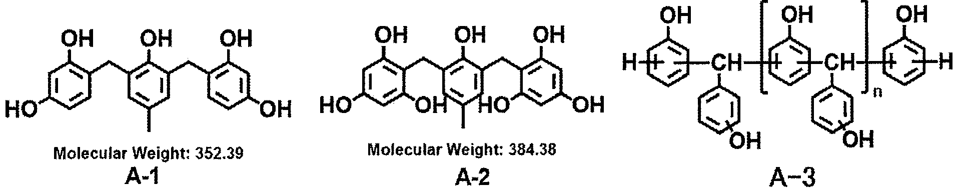

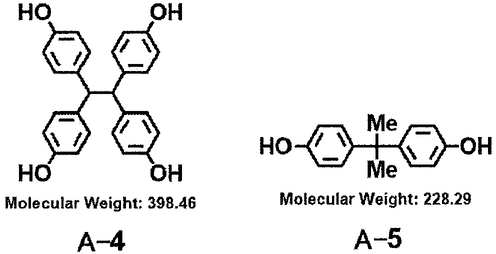

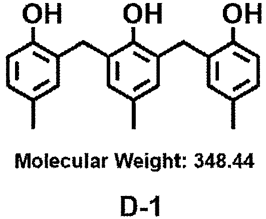

### (Acid anhydride)

Acid anhydride A-6 used in Examples or Comparative Examples will be shown below. The acid anhydride used as the curing agent in Example 14 also corresponds to compound X.

"A-6": A mixture of 3-methyl-1,2,3,6-tetrahydrophthalic acid anhydride and 4-methyl-1,2,3,6-tetrahydrophthalic acid anhydride ("HN-2200" produced by Showa Denko Materials Co., Ltd.)

### <Epoxy compound>

Epoxy compounds used in Examples or Comparative Examples will be shown below.

In addition, the B-3 is a mixture of two kinds of epoxy compounds (trade name: EPOTOHTO ZX-1059, produced by Tohto Chemical Industry Co., Ltd.).

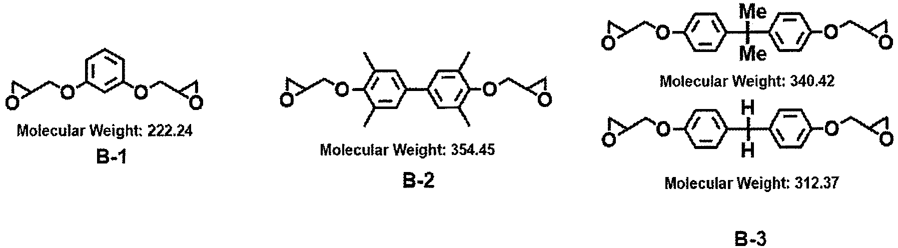

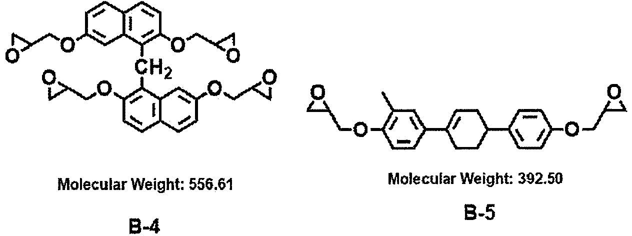

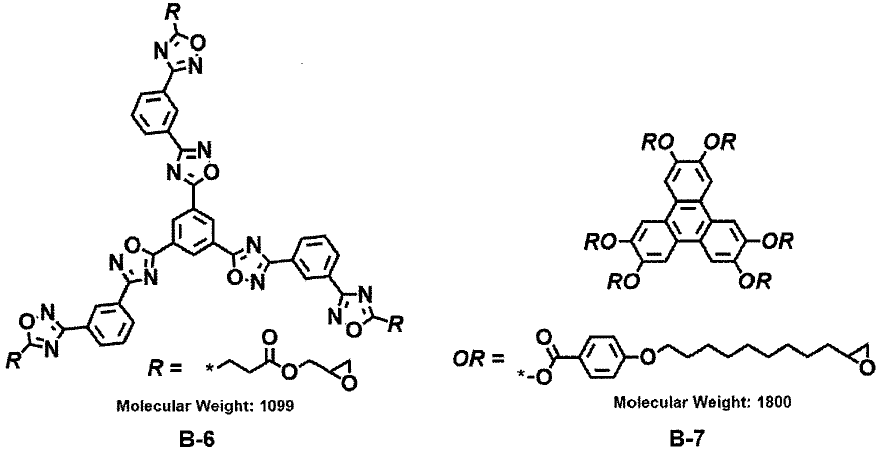

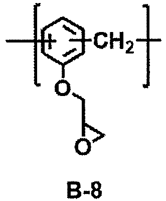

### <Inorganic substance>

Inorganic substances used in Examples or Comparative Examples will be shown below.
"HP-40 MF100": Aggregation-shaped boron nitride (average particle diameter: 40 µm, produced by MIZUSHIMA FERROALLOY CO., LTD.)
"AA-04": Alumina (average particle diameter: 0.5 µm, produced by Sumitomo Chemical Co., Ltd.)
"AA-18": Alumina (average particle diameter: 20 µm, produced by Sumitomo Chemical Co., Ltd.)

### <Curing accelerator>

PPh₃ (triphenylphosphine) was used as a curing accelerator.

### <Compound X>

Compounds X used in Examples or Comparative Examples will be shown below.
"X-1": Trimethylolpropane triacrylate ("A-TMPT" produced by SHIN-NAKAMURAakamura Chemical Industry Co., Ltd.)
"X-2": Silane coupling agent ("KBM-503" produced by Shin-Etsu Chemical Co., Ltd.)
"X-3": Curable silanol ("VF-600" produced by Shin-Etsu Chemical Co., Ltd.)
"X-4": A mixture of 3-methyl-1,2,3,6-tetrahydrophthalic acid anhydride and 4-methyl-1,2,3,6-tetrahydrophthalic acid anhydride ("HN-2200" produced by Showa Denko Materials Co., Ltd.)
"X-5": Novolac type cyanate ester resin ("XU371" produced by Huntsman Japan Corporation)
"X-6": Diaminodiphenylmethane
"X-7": Trimethylolpropane tris(3-mercaptobutyrate) ("TPMB" produced by Showa Denko K.K.)
"X-8": A polyamic acid consisting of a compound having a polyamic acid structure (3,3',4,4'-biphenyltetracarboxylic acid dianhydride and a mixture of p-phenylenediamine and 4,4'-diaminodiphenyl ether (molar ratio 5: 5))
"X-9": 2-methacryloyloxyethyl succinic acid ("Light Ester HO-MS" produced by Kyoeisha Chemical Co., Ltd.)
"X-10": Maleic acid (produced by Tokyo Chemical Industry Co., Ltd.)

### <Surface modifier>

The surface modifier used in Examples is shown below.

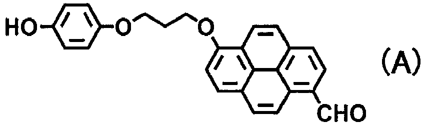

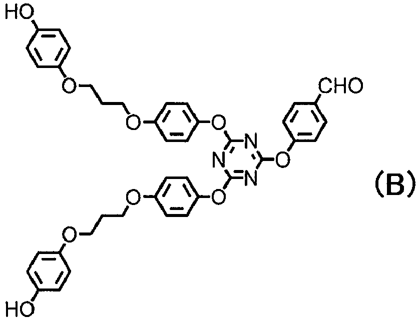

### <Solvent>

Cyclopentanone was used as the solvent.

### <Dispersant>

DISPERBYK-106 (polymer salt having an acidic group) was used as the dispersant.

### <Polymerization initiator>

The surface modifier used in Examples is shown below.
"VAm-110" (produced by FUJIFILM Wako Pure Chemical Corporation, oil-soluble azo polymerization initiator)
"AIBN" (azobisisobutyronitrile)
"PBO" (benzoyl peroxide)

### [Preparation of composition]

An epoxy compound and a curing agent (phenolic compound or acid anhydride) in the combinations shown in Table 1 below were formulated at an equivalent amount (an amount in which the number of epoxy groups in the epoxy compound is equivalent to the number of hydroxyl groups in the phenolic compound or the number of the acid anhydride groups in the acid anhydride) to prepare a curing liquid.

The curing liquid, a solvent, a compound X, a polymerization initiator, a dispersant, a surface modifier, and a curing accelerator were mixed in this order, and then an inorganic substance was added. The obtained mixture was treated for 5 minutes with a rotating and revolving mixer (produced by THINKY CORPORATION, AWATORI RENTARO ARE-310) to obtain a composition (composition for forming a thermally conductive material) of each Example or Comparative Example.

Here, an addition amount of the solvent was set such that the concentration of the solid content in the composition was 50% to 80% by mass.

In addition, the concentration of the solid content in the composition was adjusted for each composition within the range such that the viscosities of the compositions were about the same.

An addition amount of the curing accelerator was set such that the content of the curing accelerator in the composition was 1% by mass with respect to the content of the epoxy compound (column "^{∗}A" in the table). Table 1 shows the kinds of the curing accelerator used.

An addition amount of compound X was set such that the content of compound X in the composition became a value (% by mass) shown in Table 1 with respect to the total solid content of the composition. The kinds of the used compound X are shown in Table 1.

An addition amount of the polymerization initiator was set such that the content of the polymerization initiator in the composition was 1% by mass with respect to the content of the compound X (column "^{∗}B" in the table). Table 1 shows the kinds of the used polymerization initiator.

An addition amount of the inorganic substance (total of all inorganic substances) was set so that the content of the inorganic substance in the composition became a value (% by mass) shown in Table 1 with respect to the total solid content of the composition.

An addition amount of the dispersant was set such that the content of the dispersant in the composition was 0.2% by mass with respect to the content of the inorganic substance.

In a case where a surface modifier was used, an addition amount of the surface modifier was set such that the content of the surface modifier in the composition was 0.3% by mass with respect to the content of the inorganic nitride (addition amount of HP-40 MF100).

In the table, the content of the curing liquid composed of the curing agent and the epoxy compound is the remaining amount (% by mass) of the total solid content of the composition excluding the inorganic substance, the curing accelerator, the compound X, the polymerization initiator, the dispersant, and the surface modifier.

### [Evaluation]

### <Thermally conductive properties>

A prepared composition was uniformly applied onto a release surface of a release-treated polyester film (NP-100A, produced by PANAC CO., LTD., film thickness of 100 µm) by using an applicator, and left to stand at 120°C for 5 minutes to obtain a coating film.

Two polyester films with such a coating film were prepared, and after attaching the two polyester films with a coating film to coating film surfaces, the two polyester films with a coating film were hot-pressed (treated at a hot plate temperature of 65°C and a pressure of 12 MPa for one minute) in the air to obtain a semi-cured film. The obtained semi-cured film was treated with a hot press in the air (treated at a hot plate temperature 160°C and a pressure of 12 MPa for 20 minutes, and then further treated at normal pressure at 180°C for 90 minutes) to cure the coating film, and a resin sheet was obtained. The polyester films on both sides of the resin sheet were peeled off to obtain a thermally conductive sheet having an average film thickness of 200 µm.

Evaluation of thermally conductive properties was carried out using each thermally conductive sheet obtained by using each composition. The thermal conductivity was measured by the following method, and the thermally conductive properties were evaluated according to the following standard.

(Measurement of thermal conductivity (W/m·k))
(1) Using "LFA467" produced by NETZSCH, the thermal diffusivity in a thickness direction of the thermally conductive sheet was measured by a laser flash method.
(2) The specific gravity of the thermally conductive sheet was measured by the Archimedes method (using the "solid specific gravity measuring kit") using the balance "XS204" produced by Metler Toledo.
(3) Using "DSC320/6200" produced by Seiko Instruments Inc., the specific heat of the thermally conductive sheet at 25°C was determined under a temperature rising condition of 10°C/min.
(4) The obtained thermal diffusivity was multiplied by the specific gravity and the specific heat to calculate the thermal conductivity of the thermally conductive sheet.

### (Evaluation standard)

The measured thermal conductivity was classified according to the following criteria, and the thermally conductive properties were evaluated.
"A+": 13 W/m·K or more
"A": 10 W/m·K or more and less than 13 W/m·K
"B": 8 W/m·K or more and less than 10 W/m·K
"C": 5 W/m·K or more and less than 8 W/m·K
"D": Less than 5 W/m·K

The results are shown in Table 1.

### <Insulating properties>

A volume resistance value of the thermally conductive sheet prepared in the same manner as the evaluation of "thermally conductive properties" at 23°C and 65% relative humidity was measured using the Hiresta MCP-HT450 type (produced by Nittoseiko Analytech Co., Ltd.).

### (Evaluation standard)

The measured volume resistance value of the thermally conductive sheet was classified according to the following criteria, and the insulating properties were evaluated.
"A+": 10¹⁶ Ω·cm or greater
"A": 10¹⁴ Ω·cm or more and less than 10¹⁶ Ω·cm
"B": 10¹² Ω·cm or more and less than 10¹⁴ Ω·cm
"C": 10¹⁰ Ω·cm or more and less than 10¹² Ω·cm
"D": Less than 10¹⁰ Ω·cm

The results are shown in Table 1.

### <Copper peel test>

A prepared composition was uniformly applied onto a release surface of a release-treated polyester film (NP-100A, produced by PANAC CO., LTD., film thickness of 100 µm) by using an applicator, and left to stand at 120°C for 5 minutes to obtain a coating film. Such two coating films were prepared, and the two coating films were attached together at 120°C. Then, the polyester film was peeled off to obtain a laminate.

Then, the obtained laminate was sandwiched between an electrolytic copper foil (thickness: 35 µm) and aluminum (thickness: 800 µm) as an adherend, attached by a hot press (20 MPa, 120°C, 1 minute) to obtain a semi-cured sheet. Then, the semi-cured sheet was hot-pressed (5 MPa, 180°C, 5 minutes) and then cured (180°C, 90 minutes) to integrate a sheet layer (cured layer formed from the laminate) and the adherend. Then, the resultant product was cut out to a size of 20 mm × 70 mm to prepare a test piece for a peeling test.

Then, the copper foil portion of the test piece was subjected to a 90° peel test at a peeling rate of 50 mm/min using a tensile test device produced by A & D Co., Ltd., and a degree of adhesion between the adherend and the sheet layer was evaluated according to the adhesive force.

### (Evaluation standard)

The measured adhesive strength was classified according to the following criteria, and the adhesiveness was evaluated.
"A+": 5 N/cm or greater
"A": 4 N/cm or greater and less than 5 N/cm
"B": 3 N/cm or greater and less than 4 N/cm
"C": 1 N/cm or greater and less than 3 N/cm
"D": Less than 1 N/cm

### [Result]

Table 1 will be shown below.

In Table 1, the "number of functional groups" in the "curing agent" column indicates a content (mmol/g) of the used hydroxyl group of the used phenolic compound or a content (mmol/g) of the acid anhydride group of the used acid anhydride.

In the column of "structure of compound X", the column of "kind of compound X" indicates the structure of the used compound X. Specifically, a case where the used compound X is a compound (compound X1) having one or more specific functional groups selected from the group consisting of an alkenyl group, an acrylate group, a methacrylate group, a silyl group, an acid anhydride group, a cyanate ester group, an amino group, a thiol group, and a carboxylic acid group is indicated as "A", and a case where the used compound X is a compound (compound X2) having a polyamic acid structure is indicated as "B". In addition, the column of "kind of specific functional group" indicates the kind of the specific functional group contained in the used compound X1.

**[Table 1]**

| Table 1 | Constitutions of composition | | | | | | | | | | | Structure of compound X | | Evaluation | | |
|---|---|---|---|---|---|---|---|---|---|---|---|---|---|---|---|---|
| | Curing agent | | | Epoxy compound | Inorganic substance | | Curing accelerator (1% by mass (^{∗}A)) | Compound X | | Polymeriza tion initiator (1% by mass (^{∗}B)) | Kind of Surface modifier | | | Thermal conductivity | Insulating properties | Adhesiveness |
| | Kind | Molecular weight | Number of functional groups (mmol/g) | Kind | Kind | Content (% by mass) | | Kind | Content (% by mass) | | | Kind of compou nd X | Kind of specific functional group | | | |
| Example 1 | A-1 | 352 | 14.2 | B-1 | HP-40 MF100 | 76 | PPh₃ | X-1 | 20 | VAm110 | - | A | Acrylate group | A | A | A |
| Example 2 | A-1 | 352 | 14.2 | B-1 | HP-40 MF100 | 76 | PPh₃ | X-2 | 20 | VAm110 | - | A | Silyl group/methacryl ate group | A | A | A |
| Example 3 | A-1 | 352 | 14.2 | B-1 | HP-40 MF100 | 76 | PPh₃ | X-2 | 10 | VAm110 | - | A | Silyl group/methacryl ate group | B | B | B |
| Example 4 | A-1 | 352 | 14.2 | B-1 | HP-40 MF100 | 76 | PPh₃ | X-3 | 20 | VAm110 | - | A | Alkenyl group | A+ | A+ | A+ |
| Example 5 | A-1 | 352 | 14.2 | B-1 | HP-40 MF100 | 10 | PPh₃ | X-3 | 40 | VAm110 | - | A | Alkenyl group | C | C | C |
| Example 6 | A-1 | 352 | 14.2 | B-1 | HP-40 MF100 | 76 | PPh₃ | X-4 | 20 | - | - | A | Acid anhydride group | B | B | B |
| Example 7 | A-1 | 352 | 14.2 | B-1 | HP-40 MF100 | 76 | PPh₃ | X-5 | 20 | - | - | A | Cyanate ester group | B | B | B |
| Example 8 | A-1 | 352 | 14.2 | B-1 | HP-40 MF100 | 76 | PPh₃ | X-6 | 20 | - | - | A | Amino group | B | B | B |
| Example 9 | A-1 | 352 | 14.2 | B-1 | HP-40 MF100 | 76 | PPh₃ | X-7 | 20 | - | - | A | Thiol group | B | B | B |
| Example 10 | A-1 | 352 | 14.2 | B-1 | HP-40 MF100 | 76 | PPh₃ | X-9 | 20 | - | - | A | Methacrylate group carboxylic acid group | A | A | A |
| Example 11 | A-1 | 352 | 14.2 | B-1 | HP-40 MF100 | 76 | PPh₃ | X-10 | 20 | - | - | A | Carboxylic acid group | B | B | B |
| Example 12 | A-1 | 352 | 14.2 | B-1 | HP-40 MF100 | 76 | PPh₃ | X-1 | 20 | AIBN | - | A | Acrylate group | A | A | A |
| Example 13 | A-1 | 352 | 14.2 | B-1 | HP-40 MF 100 | 76 | PPh₃ | X-1 | 20 | PBO | - | A | Acrylate group | A | A | A |
| Example 14 | A-6 | 166 | 6.0 | B-1 | HP-40 MF 100 | 76 | PPh₃ | X-1 | 20 | VAmllO | - | A | Acrylate group | B | B | B |
| Example 15 | - | - | - | B-1 | HP-40 MF100 | 76 | PPh₃ | X-1 | 20 | VAm110 | - | A | Acrylate group | B | B | B |
| Example 16 | A-1 | 352 | 14.2 | B-1 | HP-40 MF100 | 76 | PPh₃ | X-1 | 20 | VAm110 | A | A | Acrylate group | A+ | A+ | A+ |
| Example 17 | A-1 | 352 | 14.2 | B-1 | HP-40 MF100 | 76 | PPh₃ | X-1 | 20 | VAm110 | B | A | Acrylate group | A+ | A+ | A+ |
| Example 18 | A-1 | 352 | 14.2 | B-1 | HP-40 MF 100/AA-04=90 /10(vol%) | 76 | PPh₃ | X-1 | 20 | VAm110 | - | A | Acrylate group | A | A | A |
| Example 19 | A-1 | 352 | 14.2 | B-1 | AA-18 | 76 | PPh₃ | X-1 | 20 | VAm110 | - | A | Acrylate group | B | B | B |
| Example 20 | A-1 | 352 | 14.2 | B-1 | HP-40 MF100 | 76 | PPh₃ | X-8 | 20 | - | - | B | - | A | A | A |
| Example 21 | A-2 | 384 | 18.2 | B-1 | HP-40 MF100 | 76 | PPh₃ | X-1 | 20 | VAm110 | - | A | Acrylate group | A | A | A |
| Example 22 | A-3 | 513 | 10.5 | B-1 | HP-40 MF100 | 76 | PPh₃ | X-1 | 20 | VAm110 | - | A | Acrylate group | C | C | C |
| Example 23 | A-4 | 398 | 10.0 | B-1 | HP-40 MF100 | 76 | PPh₃ | X-1 | 20 | VAm110 | - | A | Acrylate group | B | B | B |
| Example 24 | A-5 | 228 | 8.8 | B-1 | HP-40 MF 100 | 76 | PPh₃ | X-1 | 20 | VAm110 | - | A | Acrylate group | C | C | C |
| Example 25 | A-1 | 352 | 14.2 | B-2 | HP-40 MF100 | 76 | PPh₃ | X-1 | 20 | VAm110 | - | A | Acrylate group | A | A | A |
| Example 26 | A-1 | 352 | 14.2 | B-3 | HP-40 MF100 | 76 | PPh₃ | X-1 | 20 | VAm110 | - | A | Acrylate group | A | A | A |
| Example 27 | A-1 | 352 | 14.2 | B-4 | HP-40 MF100 | 76 | PPh₃ | X-1 | 20 | VAm110 | - | A | Acrylate group | A | A | A |
| Example 28 | A-1 | 352 | 14.2 | B-5 | HP-40 MF100 | 76 | PPh₃ | X-1 | 20 | VAm110 | - | A | Acrylate group | A | A | A |
| Example 29 | A-1 | 352 | 14.2 | B-6 | HP-40 MF100 | 76 | PPh₃ | X-1 | 20 | VAm110 | - | A | Acrylate group | A | A | A |
| Example 30 | A-1 | 352 | 14.2 | B-7 | HP-40 MF 100 | 76 | PPh₃ | X-1 | 20 | VAm110 | - | A | Acrylate group | A | A | A |
| Example 31 | A-1 | 352 | 14.2 | B-8 | HP-40 MF100 | 76 | PPh₃ | X-1 | 20 | VAm110 | - | A | Acrylate group | A | A | A |
| Comparative Example 1 | D-1 | 348 | 8.6 | B-1 | HP-40 MF100 | 76 | PPh₃ | None | None | None | - | - | - | D | D | D |
| Comparative Example 2 | A-1 | 352 | 14.2 | B-1 | HP-40 MF 100 | 76 | PPh₃ | X-2 | 1.5 | VAm110 | - | A | Silyl group/methacryl ate group | D | D | D |

From the results in Table 1, it is clear that the thermally conductive sheet formed from the composition of the example is excellent in thermally conductive properties, insulating properties, and adhesiveness.

From the comparison of Examples 1, 14, and 15, it can be seen that in a case where the phenolic compound is contained as a curing agent, the obtained thermally conductive sheet has more excellent thermally conductive properties, insulating properties, and adhesiveness.

From the comparison of Examples 1, 2, 4, 6 to 11, 20, in a case where compound X is a compound having at least one or more specific functional groups selected from the group consisting of an alkenyl group, a (meth)acrylate, and a silyl group, or a compound having a polyamic acid structure (corresponding to Examples 1, 2, 4, 10, and 20) (preferably, in a case where compound X is a compound having an alkenyl group (corresponding to Example 4)), it can be seen that the obtained thermally conductive sheet has more excellent thermally conductive properties, insulating properties, and adhesiveness.

From the comparison between Examples 2 and 3, in a case where a content of the compound X in the composition is 15% by mass or more with respect to a total solid content of the composition, it can be seen that the thermally conductive properties, insulating properties, and adhesiveness of the obtained thermally conductive sheet are more excellent.

From the comparison between Examples 4 and 5, in a case where a content of the compound X in the composition is 35% by mass or less with respect to the total solid content of the composition, it can be seen that the thermally conductive properties, insulating properties, and adhesiveness of the obtained thermally conductive sheet are more excellent.

From the comparison of Examples 1, 16, and 17, it can be seen that in a case where the composition contains a surface modifier, the thermally conductive properties, insulating properties, and adhesiveness of the obtained thermally conductive sheet are more excellent.

From the comparison of Examples 1, 18, and 19, it can be seen that in a case where the composition contains an inorganic nitride, the thermally conductive properties, insulating properties, and adhesiveness of the obtained thermally conductive sheet are more excellent.

From the comparison of Examples 1 and 21 to 24, it can be seen that in a case where a molecular weight of the phenolic compound is 400 or less and the number of functional groups is 12.0 mmol/g or more, the thermally conductive properties, insulating properties, and adhesiveness of the obtained thermally conductive sheet are more excellent.

From the results in Table 1, it is clear that the thermally conductive sheet formed from the compositions of Comparative Examples does not satisfy desired requirements.

## Claims

1. A composition for forming a thermally conductive material, comprising:
an epoxy compound,
an inorganic substance; and
a compound X containing one or more functional groups selected from the group consisting of an alkenyl group, an acrylate group, a methacrylate group, a silyl group, an acid anhydride group, a cyanate ester group, an amino group, a thiol group, and a carboxylic acid group, or having a polyamic acid structure,
wherein a content of the inorganic substance is 10% by mass or more with respect to a total solid content of the composition, and
a content of the compound X is 10% by mass or more with respect to the total solid content of the composition.

2. The composition for forming a thermally conductive material according to claim 1, further comprising:
a phenolic compound.

3. The composition for forming a thermally conductive material according to claim 2,
wherein a hydroxyl group content of the phenolic compound is 12.0 mmol/g or more.

4. The composition for forming a thermally conductive material according to claim 2 or 3,
wherein the phenolic compound has a molecular weight of 400 or less.

5. The composition for forming a thermally conductive material according to any one of claims 1 to 4,
wherein the compound X contains one or more functional groups selected from the group consisting of an alkenyl group, an acrylate group, a methacrylate group, and a silyl group, or has a polyamic acid structure.

6. The composition for forming a thermally conductive material according to any one of claims 1 to 5,
wherein the compound X is a linear or branched organopolysiloxane and has two or more alkenyl groups bonded to a silicon atom.

7. The composition for forming a thermally conductive material according to any one of claims 1 to 6,
wherein the content of the compound X is 15% to 35% by mass with respect to the total solid content of the composition.

8. The composition for forming a thermally conductive material according to any one of claims 1 to 7,
wherein the inorganic substance includes an inorganic nitride.

9. The composition for forming a thermally conductive material according to claim 8,
wherein the inorganic nitride includes boron nitride.

10. The composition for forming a thermally conductive material according to any one of claims 1 to 9, further comprising:
a surface modifier of the inorganic substance.

11. The composition for forming a thermally conductive material according to claim 10,
wherein the surface modifier has a condensed ring skeleton or a triazine skeleton.

12. The composition for forming a thermally conductive material according to any one of claims 1 to 11, further comprising:
a curing accelerator.

13. A thermally conductive material which is obtained by curing the composition for forming a thermally conductive material according to any one of claims 1 to 12.

14. A thermally conductive sheet made of the thermally conductive material according to claim 13.

15. A device with a thermally conductive layer comprising:
a device; and
a thermally conductive layer including the thermally conductive sheet according to claim 14 arranged on the device.
